# EUROPEAN PATENT APPLICATION

(11) **EP 4 768 319 A1**
(43) Date of publication of application: **01.07.2026**
(21) Application number: 25225252.3
(22) Date of filing: 18.12.2025
(51) Int. Cl.: B60L 53/302, B60L 58/26, B60L 58/32

(54) **ON-BOARD CHARGER WITH THREE-DIMENSIONAL LIQUID COOLING LOOP, POWERTRAIN, AND ELECTRIC VEHICLE**

(30) Priority: 27.12.2024 CN 202411984819
(71) Applicant: Huawei Technologies Co., Ltd., Shenzhen, Guangdong 518129 (CN)
(72) Inventor: LIAO, Weineng, Shenzhen, Guangdong, 518129 (CN); BIAN, Fei, Shenzhen, Guangdong, 518129 (CN); LIU, Hongbing, Shenzhen, Guangdong, 518129 (CN); LI, Quanming, Shenzhen, Guangdong, 518129 (CN); YAO, Zirong, Shenzhen, Guangdong, 518129 (CN); WANG, Yong, Shenzhen, Guangdong, 518129 (CN); CHEN, Sen, Shenzhen, Guangdong, 518129 (CN)
(74) Representative: Maiwald GmbH

(57) **Abstract**

This application provides an on-board charger with a three-dimensional liquid cooling loop, a powertrain, and an electric vehicle. An electrical component of the on-board charger is configured to: charge and discharge a power battery of the electric vehicle. A housing of the on-board charger includes a cover plate and an accommodation groove. The cover plate is configured to enclose the accommodation groove in a first direction, and the accommodation groove is configured to accommodate the electrical component of the on-board charger. The three-dimensional liquid cooling loop of the on-board charger includes a first liquid cooling plate, a second liquid cooling plate, a housing liquid inlet flow channel, and a housing liquid outlet flow channel. The first liquid cooling plate and the second liquid cooling plate are stacked in the first direction. The electrical component of the on-board charger is arranged between the first liquid cooling plate and the second liquid cooling plate. In this application, the first liquid cooling plate and the second liquid cooling plate are used for implementing double-sided heat dissipation for the electrical component, to enhance cooling effect on the on-board charger.

## Description

### TECHNICAL FIELD

This application relates to the field of electric vehicle technologies, and in particular, to an on-board charger with a three-dimensional liquid cooling loop, a powertrain, and an electric vehicle.

### BACKGROUND

In the new energy vehicle industry, a powertrain is a power source of an entire vehicle. In the powertrain, an on-board charger is used for charging and discharging a power battery to ensure normal traveling of the vehicle. When the on-board charger is in an operating state, an internal component of the on-board charger generates a large amount of heat. However, currently, heat dissipation effect of the on-board charger is poor, and the internal component is severely heated, negatively affecting operating efficiency of the on-board charger and the powertrain.

### SUMMARY

Embodiments of this application provide an on-board charger with a three-dimensional liquid cooling loop, a powertrain, and an electric vehicle, to enhance heat dissipation effect of the on-board charger.

According to a first aspect, an embodiment of this application provides an on-board charger. An electrical component of the on-board charger is configured to: charge and discharge a power battery of an electric vehicle. A housing of the on-board charger includes a cover plate and an accommodation groove. The cover plate is configured to enclose the accommodation groove in a first direction, and the accommodation groove is configured to accommodate the electrical component of the on-board charger.

The three-dimensional liquid cooling loop of the on-board charger includes a first liquid cooling plate, a second liquid cooling plate, a split flow channel, a housing liquid inlet flow channel, and a housing liquid outlet flow channel. The first liquid cooling plate and the second liquid cooling plate are stacked in the first direction, and the electrical component of the on-board charger is arranged between the first liquid cooling plate and the second liquid cooling plate.

The first liquid cooling plate includes a first separation protrusion, a second separation protrusion, a first communication hole, a second communication hole, a third communication hole, and a fourth communication hole. The first separation protrusion and the second separation protrusion are configured to separate a flow channel of the first liquid cooling plate into a first heat dissipation plate flow channel and a second heat dissipation plate flow channel. The split flow channel is configured for communication of the first heat dissipation plate flow channel and the second heat dissipation plate flow channel. The first separation protrusion is distributed between the first communication hole and the second communication hole, and the second separation protrusion is distributed between the third communication hole and the fourth communication hole.

The first communication hole and the third communication hole are distributed on the first heat dissipation plate flow channel, and the second communication hole and the fourth communication hole are distributed on the second heat dissipation plate flow channel. The first heat dissipation plate flow channel is configured to receive cooling liquid from the housing liquid inlet flow channel through the first communication hole, and the first heat dissipation plate flow channel is configured to deliver the cooling liquid to an inlet of a flow channel of the second liquid cooling plate through the third communication hole. The second heat dissipation plate flow channel is configured to receive the cooling liquid from an outlet of the flow channel of the second liquid cooling plate through the fourth communication hole, the second heat dissipation plate flow channel is configured to receive the cooling liquid from the first heat dissipation plate flow channel through the split flow channel, and the second heat dissipation plate flow channel is configured to deliver the cooling liquid to the housing liquid outlet flow channel through the second communication hole.

In this embodiment of this application, some electrical components have a high loss density, and generate a large amount of heat in an operating process. Heat generated by the electrical components with the high loss density generates heat reduces operating efficiency of the electrical components, and adversely affects the electrical component with a low temperature resistance level.

To resolve the foregoing problems, in embodiments of this application, the electrical component is arranged between the first liquid cooling plate and the second liquid cooling plate in the first direction. The cooling liquid in the first liquid cooling plate and the second liquid cooling plate can cool the electrical component from different angles, to cool the electrical component in a three-dimensional manner. This helps expand a cooling range of the cooling liquid in the electrical component, and avoid insufficient local cooling.

In this embodiment of this application, the housing liquid inlet flow channel and the housing liquid outlet flow channel are respectively configured to implement input and output of the cooling liquid in the on-board charger, indicating that the cooling liquid in the first liquid cooling plate and the second liquid cooling plate is in a continuous flow and update state. This helps enhance effect of cooling the electrical components by the first liquid cooling plate and the second liquid cooling plate.

In this embodiment of this application, the first liquid cooling plate and the second liquid cooling plate communicate with each other through the third communication hole and the fourth communication hole. Both the first liquid cooling plate and the second liquid cooling plate communicate with the housing liquid inlet flow channel through the first communication hole and communicate with the housing liquid outlet flow channel through the second communication hole. The first communication hole, the second communication hole, the third communication hole, and the fourth communication hole are all distributed in the first liquid cooling plate, which helps simplify a structure of the three-dimensional liquid cooling loop of the on-board charger. In addition, a cooling manner of series-parallel hybrid connection between the first liquid cooling plate and the second liquid cooling plate is designed based on heat dissipation requirements of the electrical components, to improve practicality of the first liquid cooling plate and the second liquid cooling plate.

In this embodiment of this application, the first separation protrusion and the second separation protrusion are configured to separate the first liquid cooling plate into the first heat dissipation plate flow channel and the second heat dissipation plate flow channel. In this embodiment of this application, a series-parallel hybrid connection design is implemented between the first liquid cooling plate and the second liquid cooling plate by using the first separation protrusion, the second separation protrusion, and the split flow channel. After flowing into the first heat dissipation plate flow channel through the first communication hole, the cooling liquid is split into two paths of cooling liquid at the split flow channel. One path of cooling liquid flows into the second liquid cooling plate, and the other path of cooling liquid flows into the second heat dissipation plate flow channel. Because the second liquid cooling plate communicates with the first liquid cooling plate, the cooling liquid on one channel finally flows back to the second heat dissipation plate flow channel through the second liquid cooling plate.

In this embodiment of this application, series-parallel hybrid connection is implemented between the first liquid cooling plate and the second liquid cooling plate, so that advantages of a series branch and a parallel branch can be comprehensively utilized. A flow rate of the cooling liquid in the series branch is high, and the series branch has an advantage of a small thermal resistance. The second heat dissipation plate flow channel of the first liquid cooling plate includes the series branch, which can prevent a temperature of the cooling liquid in the first liquid cooling plate from increasing excessively fast, thereby helping improve cooling efficiency of the first liquid cooling plate. A flow rate of the cooling liquid in the parallel branch is low, and the parallel branch has an advantage of a small flow resistance. The second liquid cooling plate needs to communicate with the housing liquid inlet flow channel and the housing liquid outlet flow channel through the first liquid cooling plate. The second liquid cooling plate includes one parallel branch, which helps reduce a flow resistance loss of the cooling liquid between the first liquid cooling plate and the second liquid cooling plate.

In this embodiment of this application, the first separation protrusion and the second separation protrusion separates the first liquid cooling plate into the first heat dissipation plate flow channel and the second heat dissipation plate flow channel. The first heat dissipation plate flow channel and the second heat dissipation plate flow channel communicate with each other through the split flow channel, so that the cooling liquid can flow in the pre-designed series-parallel hybrid connection manner. If the first separation protrusion and the second separation protrusion do not separate the first heat dissipation plate flow channel from the second heat dissipation plate flow channel, in other words, there is no obvious boundary between the first heat dissipation plate flow channel and the second heat dissipation plate flow channel, a flow path of the cooling liquid may be chaotic, and consequently, it is difficult to comprehensively exert advantages of the series branch and the parallel branch.

In an embodiment, the split flow channel is distributed in a gap between the first separation protrusion and the second separation protrusion.

In this embodiment of this application, the split flow channel is configured to directly communicate the first heat dissipation plate flow channel with the second heat dissipation plate flow channel. After flowing into the first heat dissipation plate flow channel through the first communication hole, the cooling liquid is split into two paths of cooling liquid at the split flow channel. One path of cooling liquid flows into the second heat dissipation plate flow channel and the second communication hole in sequence through the split flow channel, and the other path of cooling liquid also flows into the second heat dissipation plate flow channel through the third communication hole, the second liquid cooling plate, and the fourth communication hole in sequence. The cooling liquid flows into the split flow channel through the first communication hole and into the fourth communication hole through the first communication hole to form two parallel branches; and the cooling liquid in the two parallel branches converges in the second heat dissipation plate flow channel and flows into the second communication hole to form a series branch, so as to implement a cooling manner in which the first liquid cooling plate and the second liquid cooling plate are first connected in parallel and then connected in series. In this embodiment of this application, the split flow channel is integrated into the first liquid cooling plate, which helps simplify an overall structure of the three-dimensional liquid cooling loop of the on-board charger while implementing the series-parallel connection design.

In an embodiment, the split flow channel is distributed between the inlet of the flow channel of the second liquid cooling plate and the outlet of the flow channel of the second liquid cooling plate. An inlet of the split flow channel is configured to communicate with the first heat dissipation plate flow channel through the inlet of the flow channel of the second liquid cooling plate, and an outlet of the split flow channel is configured to communicate with the second heat dissipation plate flow channel through the outlet of the flow channel of the second liquid cooling plate.

In this embodiment of this application, the cooling liquid flows through the first heat dissipation plate flow channel and the inlet of the second liquid cooling plate in sequence from the first communication hole, and is split into two paths of cooling liquid at the split flow channel. One path of cooling liquid flows into the fourth communication hole and the second heat dissipation plate flow channel in sequence through the split flow channel, and the other path of cooling liquid also flows into the second heat dissipation plate flow channel through the flow channel of the second liquid cooling plate. In this embodiment of this application, a range of the series branch extends from the second heat dissipation plate flow channel to the second liquid cooling plate, which helps improve efficiency of cooling the electrical components by the second liquid cooling plate.

In an embodiment, a surface that is of the first liquid cooling plate and that faces the second liquid cooling plate in the first direction further includes a first communication port and a second communication port. A surface that is of the second liquid cooling plate and that faces the first liquid cooling plate in the first direction is used to fasten the first communication port and the second communication port. The first communication port is configured for communication of the third communication hole and the inlet of the flow channel of the second liquid cooling plate, and the second communication port is configured for communication of the fourth communication hole and the outlet of the flow channel of the second liquid cooling plate.

The split flow channel is distributed between the first communication port and the second communication port. An inlet of the split flow channel is configured to communicate with the first heat dissipation plate flow channel through the first communication port, and an outlet of the split flow channel is configured to communicate with the second heat dissipation plate flow channel through the second communication port.

In this embodiment of this application, the first communication port and the second communication port are configured for communication of the first liquid cooling plate and the second liquid cooling plate. The first communication port and the second communication port are integrated into the first liquid cooling plate and are fastened to the second liquid cooling plate, so that structural stability of the first communication port and the second communication port can be enhanced, and the cooling liquid does not leak in a process of flowing between the first liquid cooling plate and the second liquid cooling plate.

In this embodiment of this application, the split flow channel is distributed between the first communication port and the second communication port, and the split flow channel is arranged between the first liquid cooling plate and the second liquid cooling plate in the first direction. This can implement three-sided heat dissipation for the electrical components. A part of the second communication port is configured to form a series branch, which helps improve efficiency of cooling the electrical components through the second communication port.

In an embodiment, the first liquid cooling plate further includes a plurality of heat dissipation fins and a plurality of flow guide fins.

The first separation protrusion is configured to separate the first communication hole from the second communication hole. The plurality of heat dissipation fins are distributed on two sides of the first separation protrusion, and the plurality of flow guide fins are distributed on two sides of the first separation protrusion. A length of each flow guide fin is greater than a length of each heat dissipation fin, and a gap between two adjacent heat dissipation fins is less than a gap between two adjacent flow guide fins.

In this embodiment of this application, the length of the heat dissipation fin is less than the length of the flow guide fin, and the heat dissipation fins are more closely arranged than the flow guide fins. Therefore, interaction between the cooling liquid and the heat dissipation fins is stronger, and the heat dissipation fins can cause turbulence to the cooling liquid, thereby enhancing heat dissipation effect. The length of the flow guide fin is greater than the length of the heat dissipation fin, so that the cooling liquid flows in an extension direction of the flow guide fin. The flow guide fin can guide a flow direction of the cooling liquid, to implement even distribution of cooling liquid flow. Arrangement tightness of the flow guide fins is less than arrangement tightness of the heat dissipation fins, which helps reduce a flow resistance of the cooling liquid. The plurality of heat dissipation fins and the plurality of flow guide fins are integrated into the first liquid cooling plate, which helps enhance heat dissipation effect of the first liquid cooling plate.

In this embodiment of this application, the first separation protrusion is configured to separate the first communication hole from the second communication hole, so that the cooling liquid does not directly flow into the second communication hole through the first communication hole. The heat dissipation fins and the flow guide fins are distributed on the two sides of the first separation protrusion, so that the first heat dissipation plate flow channel and the second heat dissipation plate flow channel can cooperate with the heat dissipation fins and the flow guide fins.

In an embodiment, at least one of the flow guide fins or the heat dissipation fins on the two sides of the first separation protrusion differs in at least one of a quantity, a shape, or an arrangement manner.

In this embodiment of this application, layouts of the heat dissipation fins and the flow guide fins can be adjusted based on actual heat dissipation requirements of the electrical components.

In an embodiment, the first liquid cooling plate includes a flow channel groove. An orientation of a groove opening of the flow channel groove is away from an electrical component of the on-board charger in the first direction, and the flow channel groove is integrated on a surface that is of the cover plate and that is away from the accommodation groove in the first direction.

The cover plate includes a sealing plate. The sealing plate is distributed on an outer side of the accommodation groove, and the sealing plate is configured to cover the groove opening of the flow channel groove in the first direction.

In this embodiment of this application, the flow channel groove of the first liquid cooling plate is integrated into the cover plate, to help enhance structural strength of the flow channel groove. In addition, in this embodiment of this application, integration of the on-board charger can be improved, which helps implement a lightweight design of the on-board charger and optimize a layout of the powertrain.

In this embodiment of this application, air in the accommodation groove expands in volume after being heated, and the air tends to move upward to the cover plate. The flow channel groove of the first liquid cooling plate is integrated into the cover plate, which facilitates heat exchange between the first liquid cooling plate and the hot air in the accommodation groove. In addition, the first liquid cooling plate does not occupy space in the accommodation groove, which helps optimize layouts of the plurality of electrical components in the accommodation groove.

In this embodiment of this application, the first liquid cooling plate and the second liquid cooling plate can further indirectly cool the electrical component. Specifically, heat generated by the electrical component with the high loss density increases the temperature in the accommodation groove. After air is heated, the air expands in volume and decreases in a density, and therefore, the hot air tends to flow upward to the cover plate. The flow channel groove of the first liquid cooling plate is integrated into the cover plate, and cooling liquid in the flow channel groove can perform heat exchange with the hot air, and carry away heat in the air. This helps reduce a temperature in the accommodation groove and effectively improve heat dissipation efficiency.

In this embodiment of this application, the cooling liquid with a low temperature in the housing liquid inlet flow channel flows into the first liquid cooling plate through the first communication hole. The first liquid cooling plate is farther away from a groove bottom of the accommodation groove than the second liquid cooling plate, to facilitate heat exchange between the cooling liquid with the low temperature in the first liquid cooling plate and the hot air rising in the accommodation groove. This reduces the temperature in the accommodation groove.

In an embodiment, an area of a surface of the first liquid cooling plate in a second direction is greater than an area of a surface of the second liquid cooling plate in the second direction, and the second direction is perpendicular to the first direction.

In this embodiment of this application, the second direction is perpendicular to an arrangement direction of the first liquid cooling plate and the second liquid cooling plate, and the area of the surface of the first liquid cooling plate in the second direction is greater than the area of the surface of the second liquid cooling plate in the second direction. This can increase a contact area between the first liquid cooling plate and the hot air, to help reduce the temperature in the accommodation groove. In addition, the first liquid cooling plate is integrated into the cover plate. Extending a length of the first liquid cooling plate in the second direction does not interfere with layouts of the electrical components in the accommodation groove. The second liquid cooling plate is located in the accommodation groove. If the area of the surface of the second liquid cooling plate in the second direction is excessively large, clearance with the electrical component may need to be considered.

In an embodiment, a surface of the cover plate and that faces the accommodation groove in the first direction includes a plurality of fastening protrusions. The plurality of fastening protrusions are configured to fasten the circuit board and the electrical components of the on-board charger. A surface that is of the circuit board and that faces the cover plate in the first direction is used to fasten the electrical components.

In this embodiment of this application, the first liquid cooling plate is integrated on the surface that is of the cover plate and that is away from the accommodation groove, and the surface that is of the cover plate and that faces the accommodation groove is used to fasten the electrical components. The fastening protrusion is a part of the cover plate, and that the fastening protrusion is fastened to the electrical components is equivalent to that the cover plate is in direct contact with the electrical components. This can shorten a heat transmission path between the electrical components and the first liquid cooling plate without occupying space of the accommodation groove by the first liquid cooling plate, and can further reduce a risk of cooling liquid leakage.

In an embodiment, the housing liquid inlet flow channel and the housing liquid outlet flow channel are distributed on the outer side of the accommodation groove.

In this embodiment of this application, the housing liquid inlet flow channel communicates with the flow channel of the first liquid cooling plate through the first communication hole, and the housing liquid outlet flow channel communicates with the flow channel of the first liquid cooling plate through the second communication hole. The flow channel groove is distributed on a surface that is of the cover plate and that is away from the groove bottom the accommodation groove. The first communication hole and the second communication hole are distributed on a groove bottom of the flow channel groove. In other words, the first communication hole and the second communication hole are closer to the outer side of the accommodation groove than the second liquid cooling plate. If the housing liquid inlet flow channel and the housing liquid outlet flow channel are distributed on an inner side of the accommodation groove, difficulty and processing costs of communicating the housing liquid inlet flow channel and the housing liquid outlet flow channel with the first liquid cooling plate are increased, and the housing liquid inlet flow channel and the housing liquid outlet flow channel further occupy internal space of the accommodation groove.

In an embodiment, an outlet of the housing liquid inlet flow channel is configured to communicate with the first communication hole, and an orientation of the outlet of the housing liquid inlet flow channel is the same as an orientation of a groove opening of the accommodation groove.

The surface that is of the cover plate and that faces the accommodation groove in the first direction is used to fasten a flow channel communication component, and the flow channel communication component is distributed on the outer side of the accommodation groove. One end of the flow channel communication component is configured to cover the first communication hole, and the other end of the flow channel communication component is configured to be embedded in the outlet of the housing liquid inlet flow channel.

In this embodiment of this application, the flow channel communication component is configured for communication of the outlet of the housing liquid inlet flow channel and the first communication hole of the first liquid cooling plate. Both the housing liquid inlet flow channel and the flow channel communication component are distributed on the outer side of the accommodation groove, to facilitate checking of communication and reduce communication difficulty. The one end of the flow channel communication component covers the first communication hole, and the other end of the flow channel communication component is embedded in the outlet of the housing liquid inlet flow channel, so that the cooling liquid does not leak at a joint between the flow channel communication component, and the housing liquid inlet flow channel and the cover plate.

In an embodiment, an inlet of the housing liquid outlet flow channel is configured to receive the cooling liquid output by the first liquid cooling plate, and an outlet of the housing liquid outlet flow channel is configured to drain the cooling liquid from the on-board charger.

The inlet of the housing liquid outlet flow channel is distributed on a groove wall of the accommodation groove, and the outlet of the housing liquid outlet flow channel is distributed on the outer side of the accommodation groove. An orientation of the inlet of the housing liquid outlet flow channel is opposite to an orientation of the second communication hole, and the second communication hole is embedded in the inlet of the housing liquid outlet flow channel.

In this embodiment of this application, the first liquid cooling plate is integrated into the cover plate, and the cover plate and the accommodation groove are stacked in the first direction. The inlet of the housing liquid outlet flow channel is arranged on the groove wall of the accommodation groove, and the orientation of the inlet of the housing liquid outlet flow channel is opposite to the orientation of the second communication hole, to help shorten a transmission distance of the cooling liquid between the second communication hole and the housing liquid outlet flow channel. The outlet of the housing liquid outlet flow channel is arranged on the outer side of the accommodation groove, and the second communication hole is embedded in the inlet of the housing liquid outlet flow channel, to prevent the cooling liquid with a high temperature from leaking into the accommodation groove.

In an embodiment, the groove wall of the accommodation groove includes a first groove wall section and a second groove wall section. The first groove wall section and the second groove wall section are arranged opposite to each other in the second direction, and the second direction is perpendicular to the first direction.

A distance between the first groove wall section and each of the first communication hole, the second communication hole, the third communication hole, the fourth communication hole, the outlet of the housing liquid inlet flow channel, and the inlet of the housing liquid outlet flow channel is less than a distance between the second groove wall section and each of the first communication hole, the second communication hole, the third communication hole, the fourth communication hole, the outlet of the housing liquid inlet flow channel, and the inlet of the housing liquid outlet flow channel.

In this embodiment of this application, the first communication hole, the second communication hole, the third communication hole, and the fourth communication hole are all adjacent to the first groove wall section of the accommodation groove, so that the first communication hole, the second communication hole, the third communication hole, and the fourth communication hole are compactly arranged. This reduces difficulty and costs of processing the flow channel groove. The third communication hole and the fourth communication hole are adjacent to the first groove wall section of the accommodation groove, so that the first communication port and the second communication port are also close to the accommodation groove in the second direction, and space that is in the accommodation groove and that is for accommodating the electrical components can be increased. The first communication hole and the second communication hole are adjacent to the first groove wall section of the accommodation groove, so that the first communication hole and the second communication hole communicate with the housing liquid inlet flow channel and the housing liquid outlet flow channel that are distributed on the outer side of the accommodation groove.

According to a second aspect, an embodiment of this application provides a powertrain. The powertrain includes a drive motor, a reducer, and the on-board charger according to any embodiment of the first aspect. The on-board charger is configured to charge and discharge the power battery, the power battery is configured to supply power to the drive motor, and the drive motor is configured to be in transmission connection to the reducer.

In this embodiment of this application, the on-board charger according to any embodiment of the first aspect is used in the powertrain, to enhance heat dissipation effect of the on-board charger. This helps the on-board charger operate at a proper temperature, and ensures normal operation of the powertrain.

According to a third aspect, an embodiment of this application provides an electric vehicle. The electric vehicle includes a power battery and the powertrain according to any embodiment of the second aspect. The powertrain is configured to: receive power supplied by the power battery, and drive wheels of the electric vehicle.

In this embodiment of this application, the powertrain according to any embodiment of the second aspect is used in the electric vehicle, so that the powertrain is in a normal and stable operating environment, thereby improving vehicle performance.

### BRIEF DESCRIPTION OF DRAWINGS

To describe technical solutions in embodiments of this application more clearly, the following describes the accompanying drawings used in embodiments of this application.
FIG. 1 is a diagram of an electric vehicle according to an embodiment of this application;
FIG. 2 is a diagram of a powertrain according to an embodiment of this application;
FIG. 3 is a partial exploded view of an on-board charger according to an embodiment of this application;
FIG. 4 is a diagram of an on-board charger according to an embodiment of this application;
FIG. 5 is a diagram of an on-board charger according to an embodiment of this application;
FIG. 6 is a partial view of an on-board charger according to an embodiment of this application;
FIG. 7 is a partial view of an on-board charger according to an embodiment of this application;
FIG. 8 is a partial view of an on-board charger according to an embodiment of this application;
FIG. 9 is a partial sectional view of a cover plate according to an embodiment of this application;
FIG. 10 is a partial sectional view of a cover plate according to an embodiment of this application;
FIG. 11 is a partial sectional view of a cover plate according to an embodiment of this application;
FIG. 12 is a diagram of a cover plate according to an embodiment of this application;
FIG. 13 is a diagram of a powertrain according to an embodiment of this application;
FIG. 14 is a partial view of an on-board charger according to an embodiment of this application; and
FIG. 15 is a partial view of an on-board charger according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

For ease of understanding, the following first explains and describes related technical terms used in embodiments of this application.

Perpendicular: "Perpendicular" defined in embodiments of this application is not limited to an absolute perpendicular intersection relationship. A case in which there is no absolute perpendicular intersection due to factors such as an assembling tolerance, a design tolerance, and structural flatness is allowed. An error within a small angle range is allowed. For example, a range from 80 degrees to 100 degrees may be understood as a perpendicular relationship.

Parallel: "Parallel" defined in embodiments of this application is not limited to absolute parallelism. A definition of parallelism herein may be understood as basic parallelism. A case in which there is no absolute parallelism due to factors such as an assembly tolerance, a design tolerance, and structural flatness is allowed.

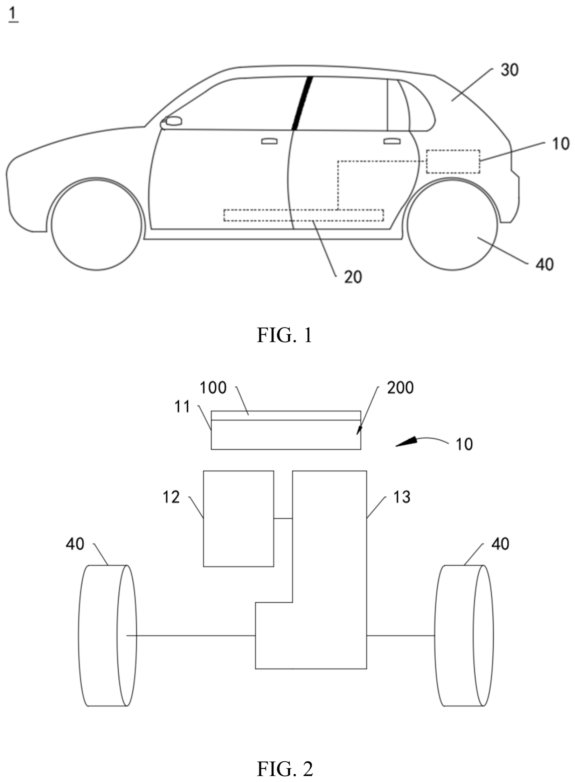

FIG. 1 is a diagram of an electric vehicle 1 according to an embodiment of this application. In an embodiment, the electric vehicle 1 includes a powertrain 10 and a power battery 20. In an embodiment, the electric vehicle 1 further includes a vehicle frame 30. The vehicle frame 30 is configured to mount the powertrain 10 and the power battery 20. The vehicle frame 30 is a structural framework of the electric vehicle 1, and can bear internal and external environment loads of the electric vehicle 1. In this embodiment of this application, the electric vehicle 1 is a wheeled device driven or towed by a power apparatus. The power battery 20 is configured to supply power to the powertrain 10. The power battery 20 may also be referred to as a battery pack. The powertrain 10 is a power source of the electric vehicle 1, and the powertrain 10 is configured to drive wheels 40 of the electric vehicle 1.

FIG. 2 is a diagram of a powertrain 10 according to an embodiment of this application. In an embodiment, the powertrain 10 includes an on-board charger 11, a drive motor 12, and a reducer 13. The on-board charger 11 includes an electrical component 300, and the on-board charger 11 is configured to: charge and discharge the power battery 20 through the electrical component 300. The power battery 20 is configured to supply power to the drive motor 12. The drive motor 12 is configured to: convert, into mechanical energy, electric energy transferred by the power battery 20, and then transfer the mechanical energy to the reducer 13, to drive the wheels 40 to rotate.

In an embodiment, the on-board charger 11 is configured to: convert an alternating current into a direct current, and then transfer the direct current to the powertrain 10 for charging, or the on-board charger 11 is configured to directly transfer a direct current to the power battery 20 for charging. The alternating current includes mains or a civil alternating current.

In an embodiment, the on-board charger 11 further supplies power to a load of the electric vehicle 1 by using the power battery 20. The load of the electric vehicle 1 includes at least one of a low-voltage battery, a vehicle light, a wiper, an air conditioner, a sound box, a universal serial bus interface, a dashboard, and a control display. The low-voltage battery may also supply power to another load of the electric vehicle 1.

In an embodiment, the powertrain 10 further includes a motor controller. The motor controller is configured to: convert, into an alternating current, the direct current transferred by the power battery 20, and transfer the alternating current to the drive motor 12.

In an operating process of the powertrain 10, the electrical component 300 of the on-board charger 11 generates heat. If cooling efficiency is low, the electrical component 300 may be overheated. Consequently, the electrical component 300 is at a risk of aging and failure due to overtemperature, affecting operating efficiency of the on-board charger 11 and the powertrain 10.

In this embodiment of this application, a cooling manner of the on-board charger 11 is improved, so that heat dissipation efficiency can be improved, and the on-board charger 11 and the powertrain 10 can run normally.

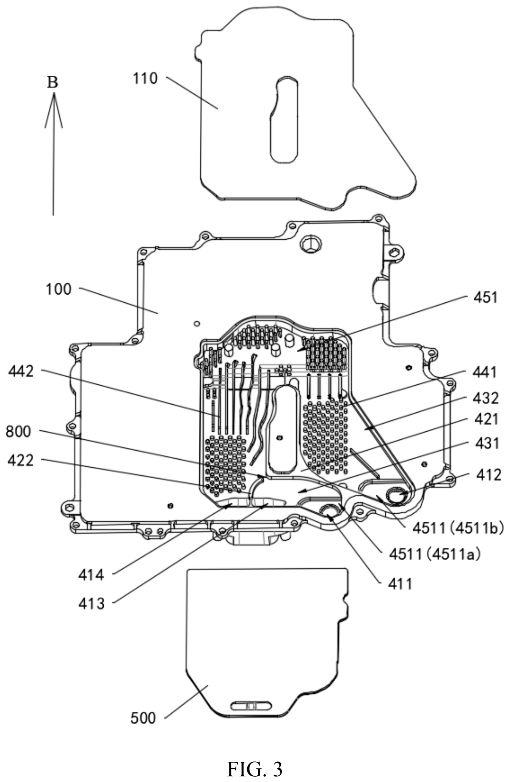

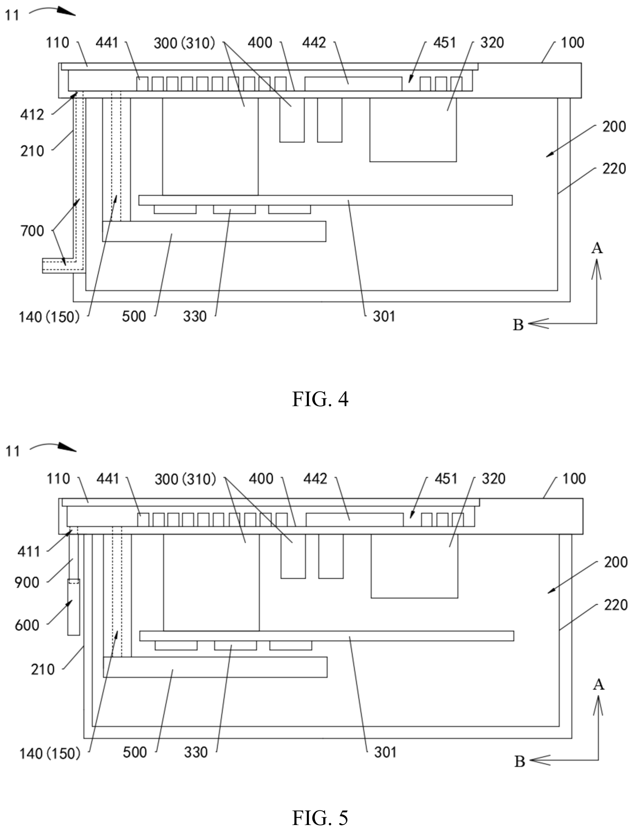

Refer to FIG. 2 to FIG. 5. FIG. 3 is a partial exploded view of an on-board charger 11 according to an embodiment of this application. FIG. 4 is a diagram of an on-board charger 11 according to an embodiment of this application. FIG. 5 is a diagram of an on-board charger 11 according to an embodiment of this application. It should be noted that FIG. 4 and FIG. 5 show only example location relationships of the components in the on-board charger 11, and do not represent specific sizes, shapes, and structures of the components. In addition, a first communication hole and a housing liquid inlet flow channel are hidden in FIG. 4, and a second communication hole and a housing liquid outlet flow channel are hidden in FIG. 5.

An embodiment of this application provides an on-board charger 11. A housing of the on-board charger 11 includes a cover plate 100 and an accommodation groove 200. The cover plate 100 is configured to enclose the accommodation groove 200 in a first direction A, and the accommodation groove 200 is configured to accommodate the electrical component 300 of the on-board charger 11.

A three-dimensional liquid cooling loop of the on-board charger 11 includes a first liquid cooling plate 400, a second liquid cooling plate 500, a housing liquid inlet flow channel 600, and a housing liquid outlet flow channel 700. At least one of the first liquid cooling plate 400 or the second liquid cooling plate 500 receives cooling liquid through the housing liquid inlet flow channel 600, and at least one of the first liquid cooling plate 400 or the second liquid cooling plate 500 outputs the cooling liquid through the housing liquid outlet flow channel 700.

The housing liquid inlet flow channel 600 and the housing liquid outlet flow channel 700 are distributed on an outer side of the accommodation groove 200. The first liquid cooling plate 400 and the second liquid cooling plate 500 are stacked in the first direction A, the electrical component 300 of the on-board charger 11 is arranged between the first liquid cooling plate 400 and the second liquid cooling plate 500, and the second liquid cooling plate 500 is arranged between a circuit board 301 of the on-board charger 11 and a groove bottom of the accommodation groove 200.

In this embodiment of this application, the cover plate 100 is stacked on the accommodation groove 200 in the first direction A, and the cover plate 100 and the housing jointly accommodate and protect a plurality of electrical components 300 of the on-board charger 11. That the electrical component 300 is configured to: charge and discharge the power battery 20 means that the electrical component 300 can process the electric energy and transfer the electric energy to the power battery 20, and can further process the electric energy from the power battery 20 and transfer the electric energy to the load of the electric vehicle 1. In an embodiment, a function of the electrical component 300 includes at least one of filtering, energy storage, rectification, inversion, and voltage transformation.

In this embodiment of this application, some electrical components 300 have a high loss density, and generate a large amount of heat in an operating process. Generating heat by the electrical components 300 with the high loss density reduces operating efficiency of the electrical components 300, and increases an air temperature in the accommodation groove 200. Consequently, the electrical component 300 with a low temperature resistance level in the accommodation groove 200 are also adversely affected. The loss density is an energy loss density in the operating process, and the temperature resistance level is a maximum allowable operating temperature.

To resolve the foregoing problems, in embodiments of this application, the electrical component 300 is arranged between the first liquid cooling plate 400 and the second liquid cooling plate 500 in the first direction A. The cooling liquid in the first liquid cooling plate 400 and the second liquid cooling plate 500 can cool the electrical component 300 from different angles, to cool the electrical component 300 in a three-dimensional manner. This helps expand a cooling range of the cooling liquid in the electrical component 300, and avoid insufficient local cooling. In an embodiment, the cooling liquid in the first liquid cooling plate 400 and the second liquid cooling plate 500 can further separately cool the electrical components 300 at different locations.

In this embodiment of this application, the first liquid cooling plate 400 and the second liquid cooling plate 500 can further indirectly cool the electrical component 300. Specifically, heat generated by the electrical component 300 with the high loss density increases the temperature in the accommodation groove 200. After air is heated, the air expands in volume and decreases in a density, and therefore, the hot air tends to flow upward to the cover plate 100. Both the first liquid cooling plate 400 and the second liquid cooling plate 500 are located on a side that is of the groove bottom of the accommodation groove 200 and that faces the cover plate 100 in the first direction A. The first liquid cooling plate 400 and the second liquid cooling plate 500 exchange heat with the hot air, to carry away the heat in the air. This helps reduce the temperature in the accommodation groove, so that an electrical component with a large heat generation amount or a low temperature resistance level is in an environment with a proper temperature, thereby effectively improving heat dissipation efficiency. If the first liquid cooling plate 400 and the second liquid cooling plate 500 are integrated into the groove bottom of the accommodation groove 200, it is difficult for the first liquid cooling plate 400 and the second liquid cooling plate 500 to cool the rising hot air, and effect of reducing the air temperature in the accommodation groove is limited.

In this embodiment of this application, the three-dimensional liquid cooling loop of the on-board charger 11 further includes the housing liquid inlet flow channel 600 and the housing liquid outlet flow channel 700. Both the housing liquid inlet flow channel 600 and the housing liquid outlet flow channel 700 are distributed on an outer side of the accommodation groove 200, to facilitate checking communication, and do not occupy internal space of the accommodation groove 200. The housing liquid inlet flow channel 600 and the housing liquid outlet flow channel 700 are respectively configured to implement input and output of cooling liquid in the on-board charger 11, indicating that the cooling liquid in the first liquid cooling plate 400 and the second liquid cooling plate 500 is in a continuous flow and update state. This helps enhance effect of cooling the electrical components 300 by the first liquid cooling plate 400 and the second liquid cooling plate 500.

In an embodiment, the housing liquid inlet flow channel 600 and the housing liquid outlet flow channel 700 are configured to communicate with a cooling system outside the on-board charger 11. The cooling system outside the on-board charger is configured to implement circulation of the cooling liquid in the first liquid cooling plate 400 and the second liquid cooling plate 500.

In an embodiment, a communication relationship between the first liquid cooling plate 400 and the second liquid cooling plate 500, and the housing liquid inlet flow channel 600 may include the following cases. One of the first liquid cooling plate 400 or the second liquid cooling plate 500 is configured to: receive cooling liquid in the housing liquid inlet flow channel 600, and deliver the cooling liquid to the other of the first liquid cooling plate 400 or the second liquid cooling plate 500. Alternatively, both the first liquid cooling plate 400 and the second liquid cooling plate 500 are configured to receive cooling liquid in the housing liquid inlet flow channel 600. In an embodiment, a communication relationship between the first liquid cooling plate 400 and the second liquid cooling plate 500, and the housing liquid outlet flow channel 700 may include the following cases. One of the first liquid cooling plate 400 or the second liquid cooling plate 500 is configured to: receive cooling liquid delivered by the other of the first liquid cooling plate 400 or the second liquid cooling plate 500, and output the cooling liquid to the housing liquid outlet flow channel 700. Alternatively, both the first liquid cooling plate 400 and the second liquid cooling plate 500 are configured to output cooling liquid to the housing liquid outlet flow channel 700. It may be understood that the connection relationship between the first liquid cooling plate 400 and the second liquid cooling plate 500, and the housing liquid inlet flow channel 600 may be combined with the connection relationship between the first liquid cooling plate 400 and the second liquid cooling plate 500, and the housing liquid outlet flow channel 700 based on an actual situation.

In an embodiment, the cooling liquid may alternatively be cooling water or cooling oil.

Still refer to FIG. 3 to FIG. 5. In an embodiment, the first liquid cooling plate 400 includes a first communication hole 411 and a second communication hole 412. The first liquid cooling plate 400 is configured to receive the cooling liquid from the housing liquid inlet flow channel 600 through the first communication hole 411, and the first liquid cooling plate 400 is configured to output the cooling liquid to the housing liquid outlet flow channel 700 through the second communication hole 412. The second liquid cooling plate 500 is configured to: receive and output the cooling liquid through the first liquid cooling plate 400.

The first communication hole 411 and the second communication hole 412 separately penetrate the first liquid cooling plate 400 in the first direction A, and both an opening orientation of the first communication hole 411 and an opening orientation of the second communication hole 412 are opposite to a groove opening orientation of the accommodation groove 200.

In this embodiment of this application, both the first liquid cooling plate 400 and the second liquid cooling plate 500 communicate with the housing liquid inlet flow channel 600 through the first communication hole 411 and communicate with the housing liquid outlet flow channel 700 through the second communication hole 412. The first communication hole 411 and the second communication hole 412 are distributed in the first liquid cooling plate 400, which helps simplify a structure of the three-dimensional liquid cooling loop of the on-board charger 11. In addition, a cooling manner of series connection, parallel connection, or series-parallel hybrid connection between the first liquid cooling plate 400 and the second liquid cooling plate 500 is designed based on heat dissipation requirements of different electrical components 300, to improve practicality of the first liquid cooling plate 400 and the second liquid cooling plate 500.

In this embodiment of this application, the cooling liquid with a low temperature in the housing liquid inlet flow channel 600 flows into the first liquid cooling plate 400 through the first communication hole 411. The first liquid cooling plate 400 is farther away from the groove bottom of the accommodation groove 200 than the second liquid cooling plate 500, to facilitate heat exchange between the cooling liquid with the low temperature in the first liquid cooling plate 400 and the hot air rising in the accommodation groove 200. This reduces the temperature in the accommodation groove 200.

In this embodiment of this application, opening orientations of the first communication hole 411 and the second communication hole 412 are parallel to the direction in which the cover plate 100 and the accommodation groove 200 are stacked, to help reduce processing difficulty of the first communication hole 411 and the second communication hole 412. In this embodiment of this application, because the on-board charger 11 occupies specific space in the first direction A, and both the opening orientation of the first communication hole 411 and the opening orientation of the second communication hole 412 are opposite to the groove opening orientation of the accommodation groove 200, the housing liquid inlet flow channel 600 and the housing liquid outlet flow channel 700 can be arranged on an outer peripheral side of the accommodation groove 200, and a length of the on-board charger 11 in the first direction A can be controlled, to implement a miniaturization design of the on-board charger 11.

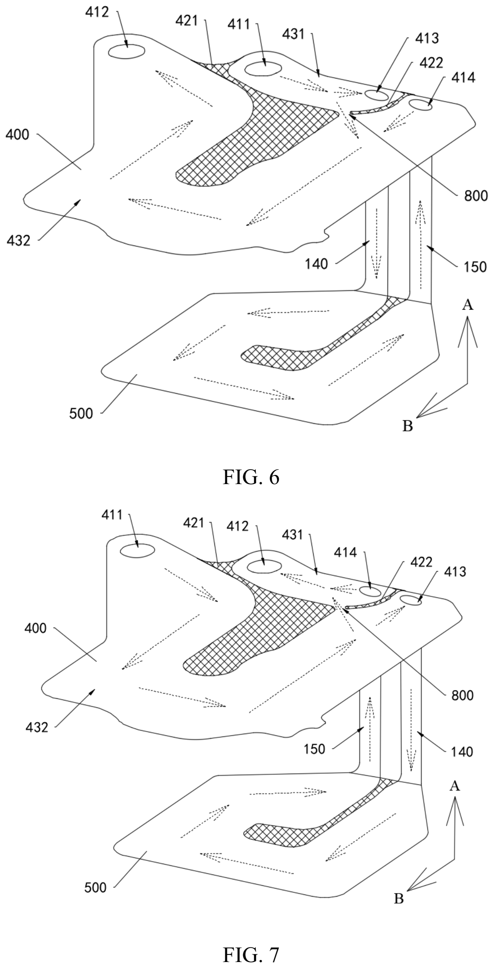

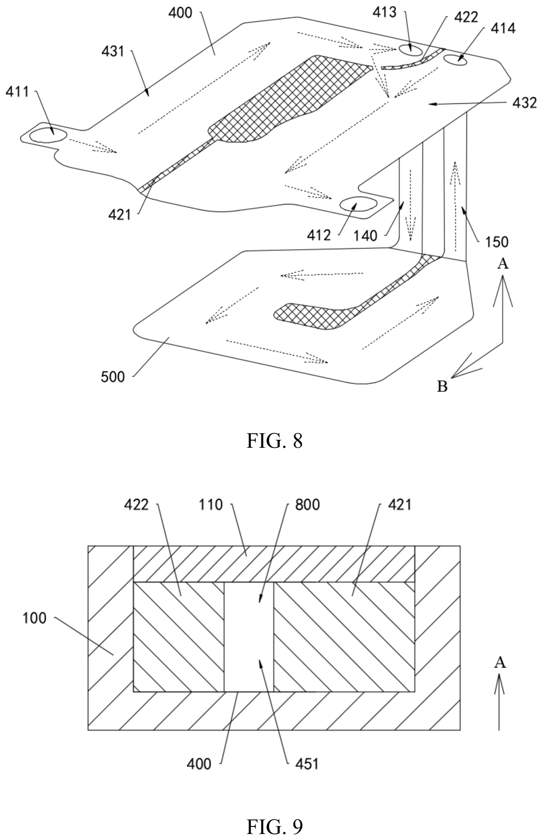

Refer to FIG. 3 and FIG. 6 to FIG. 8. FIG. 6 is a partial view of an on-board charger 11 according to an embodiment of this application. FIG. 7 is a partial view of an on-board charger 11 according to an embodiment of this application. FIG. 8 is a partial view of an on-board charger 11 according to an embodiment of this application. In FIG. 6 to FIG. 8, dashed arrows indicate a flow direction of the cooling liquid.

In an embodiment, the first liquid cooling plate 400 further includes a third communication hole 413, a fourth communication hole 414, a first separation protrusion 421, and a second separation protrusion 422. The third communication hole 413 is configured to communicate an inlet of the second liquid cooling plate 500 with the first liquid cooling plate 400, and the fourth communication hole 414 is configured to communicate an outlet of the second liquid cooling plate 500 with the first liquid cooling plate 400.

The first separation protrusion 421 and the second separation protrusion 422 are configured to separate a flow channel of the first liquid cooling plate 400 into the first heat dissipation plate flow channel 431 and the second heat dissipation plate flow channel 432. The first heat dissipation plate flow channel 431 and the second heat dissipation plate flow channel 432 are configured to communicate with each other through a split flow channel 800. The split flow channel 800 is distributed in a gap between the first separation protrusion 421 and the second separation protrusion 422. The first communication hole 411 and the third communication hole 413 are configured to communicate with the first heat dissipation plate flow channel 431, and the second communication hole 412 and the fourth communication hole 414 are configured to communicate with the second heat dissipation plate flow channel 432.

In this embodiment of this application, the third communication hole 413 and the fourth communication hole 414 are configured to communicate the first liquid cooling plate 400 with the second liquid cooling plate 500. In an embodiment, openings of the third communication hole 413 and the fourth communication hole 414 face the second liquid cooling plate 500 in the first direction A.

In this embodiment of this application, a series-parallel hybrid connection design is implemented between the first liquid cooling plate 400 and the second liquid cooling plate 500 by using the first separation protrusion 421 and the second separation protrusion 422. Specifically, as shown in FIG. 6, after flowing into the first heat dissipation plate flow channel 431 through the first communication hole 411, the cooling liquid is split into two paths of cooling liquid at the split flow channel 800 of the first separation protrusion 421 and the second separation protrusion 422. One path of cooling liquid flows into the second heat dissipation plate flow channel 432 and the second communication hole 412 in sequence through the split flow channel 800. The other path of cooling liquid flows into the second heat dissipation plate flow channel 432 in sequence through the third communication hole 413, the second liquid cooling plate 500, and the fourth communication hole 414. The cooling liquid flows into the split flow channel 800 through the first communication hole 411 and into the fourth communication hole 414 through the first communication hole 411 to form two parallel branches; and the cooling liquid in the two parallel branches converges in the second heat dissipation plate flow channel 432 and flows into the second communication hole 412 to form a series branch, so as to implement a cooling manner in which the first liquid cooling plate 400 and the second liquid cooling plate 500 are first connected in parallel and then connected in series.

In this embodiment of this application, series-parallel hybrid connection is implemented between the first liquid cooling plate 400 and the second liquid cooling plate 500, so that advantages of the series branch and the parallel branches can be comprehensively utilized. A flow rate of the cooling liquid in the series branch is high, and the series branch has an advantage of a small thermal resistance. The first liquid cooling plate 400 needs to cool the electrical component 300 and the hot air in the accommodation groove 200. The second heat dissipation plate flow channel 432 of the first liquid cooling plate 400 includes the series branch, which can prevent a temperature of the cooling liquid in the first liquid cooling plate 400 from increasing excessively fast, thereby helping improve cooling efficiency of the first liquid cooling plate 400. A flow rate of the cooling liquid in the parallel branch is low, and the parallel branch has an advantage of a small flow resistance. The second liquid cooling plate 500 needs to communicate with the first communication hole 411 and the second communication hole 412 through the first liquid cooling plate 400. The second liquid cooling plate 500 includes one parallel branch, which helps reduce a flow resistance loss of the cooling liquid between the first liquid cooling plate 400 and the second liquid cooling plate 500.

In this embodiment of this application, the first separation protrusion 421 and the second separation protrusion 422 separates the first liquid cooling plate 400 into the first heat dissipation plate flow channel 431 and the second heat dissipation plate flow channel 432. The first heat dissipation plate flow channel 431 and the second heat dissipation plate flow channel 432 communicate with each other through the split flow channel 800, so that the cooling liquid can flow in the pre-designed series-parallel hybrid connection manner. If the first separation protrusion 421 and the second separation protrusion 422 do not separate the first heat dissipation plate flow channel 431 from the second heat dissipation plate flow channel 432, in other words, there is no obvious boundary between the first heat dissipation plate flow channel 431 and the second heat dissipation plate flow channel 432, a flow path of the cooling liquid may be chaotic, and consequently, it is difficult to comprehensively exert advantages of the series branch and the parallel branch.

As shown in FIG. 7, in an embodiment, the first communication hole 411 and the second communication hole 412 are interchangeable relative to the first heat dissipation plate flow channel 431 and the second heat dissipation plate flow channel 432 in terms of locations. To be specific, the first communication hole 411 and the third communication hole 413 are configured to communicate with the second heat dissipation plate flow channel 432, and the second communication hole 412 and the fourth communication hole 414 are configured to communicate with the first heat dissipation plate flow channel 431. The third communication hole 413 and the fourth communication hole 414 are respectively configured to communicate with the inlet and the outlet of the second liquid cooling plate 500. Therefore, locations of the third communication hole 413 and the fourth communication hole 414 change with locations of the first communication hole 411 and the second communication hole 412. In this embodiment of this application, after flowing into the second heat dissipation plate flow channel 432 through the first communication hole 411, the cooling liquid is split into two paths of cooling liquid at the split flow channel 800. One path of cooling liquid flows into the first heat dissipation plate flow channel 431 and the second communication hole 412 in sequence through the split flow channel 800. The other path of cooling liquid also flows into the first heat dissipation plate flow channel 431 and the second communication hole 412 in sequence through the third communication hole 413, the second liquid cooling plate 500, and the fourth communication hole 414 in sequence. In this case, a cooling manner in which the first liquid cooling plate 400 and the second liquid cooling plate 500 are first connected in series and then connected in parallel is implemented.

As shown in FIG. 8, in an embodiment, a cooling manner in which the first liquid cooling plate 400 and the second liquid cooling plate 500 are connected in series in the front and rear and connected in parallel in the middle may alternatively be implemented by changing distances between the third communication hole 413 and the fourth communication hole 414, and the split flow channel 800, the first communication hole 411, and the second communication hole 412, and shapes of the first separation protrusion 421 and the second separation protrusion 422.

It should be noted that FIG. 6 to FIG. 8 show only examples of the serial-parallel hybrid connection manners of the first liquid cooling plate 400 and the second liquid cooling plate 500, and dashed arrows indicate only a movement trend of the cooling liquid, and does not indicate that the cooling liquid can flow only along the dashed arrows.

Still refer to FIG. 3 and FIG. 6. In an embodiment, the first separation protrusion 421 is distributed between the first communication hole 411 and the second communication hole 412, and the second separation protrusion 422 is distributed between the third communication hole 413 and the fourth communication hole 414.

A distance between the split flow channel 800 and the third communication hole 413 is less than a distance between the split flow channel 800 and the first communication hole 411, and a distance between the split flow channel 800 and the fourth communication hole 414 is less than a distance between the split flow channel 800 and the second communication hole 412.

In this embodiment of this application, the first separation protrusion 421 is configured to separate the first communication hole 411 from the second communication hole 412, and the second separation protrusion 422 is configured to separate the third communication hole 413 from the fourth communication hole 414. This helps prevent the cooling liquid from directly flowing from the first communication hole 411 into the second communication hole 412, and prevent the cooling liquid from directly flowing from the third communication hole 413 into the fourth communication hole 414.

In this embodiment of this application, in the first communication hole 411 and the third communication hole 413, the distance between the split flow channel 800 and the third communication hole 413 is shorter. In the second communication hole 412 and the fourth communication hole 414, the distance between the split flow channel 800 and the fourth communication hole 414 is shorter. According to this embodiment of this application, a path of cooling liquid flowing from the first communication hole 411 to the second communication hole 412 can be extended, and time for heat exchange between the cooling liquid and a heat source is increased.

Still refer to FIG. 3 and FIG. 4. In an embodiment, the first liquid cooling plate 400 further includes a plurality of heat dissipation fins 441 and a plurality of flow guide fins 442. The first separation protrusion 421 is configured to separate the first communication hole 411 from the second communication hole 412, so that the second heat dissipation plate flow channel 432 forms a U-shaped flow channel. The plurality of heat dissipation fins 441 are distributed on two sides of the first separation protrusion 421, and the plurality of flow guide fins 442 are distributed on two sides of the first separation protrusion 421. A length of each flow guide fin 442 is greater than a length of each heat dissipation fin 441, and a gap between two adjacent heat dissipation fins 441 is less than a gap between two adjacent flow guide fins 442.

In this embodiment of this application, the length of the heat dissipation fin 441 is less than the length of the flow guide fin 442, and the heat dissipation fins 441 are more closely arranged than the flow guide fins 442. Therefore, interaction between the cooling liquid and the heat dissipation fins 441 is stronger, and the heat dissipation fins 441 can cause turbulence to the cooling liquid, thereby enhancing heat dissipation effect. The length of the flow guide fin 442 is greater than the length of the heat dissipation fin, so that the cooling liquid flows in an extension direction of the flow guide fin 442. The flow guide fin 442 can guide a flow direction of the cooling liquid, to implement even distribution of cooling liquid flow. Arrangement tightness of the flow guide fins 442 is less than arrangement tightness of the heat dissipation fins 441, which helps reduce a flow resistance of the cooling liquid.

In this embodiment of this application, the first separation protrusion 421 is configured to separate the second heat dissipation plate flow channel 432 into the U-shaped flow channel, and is configured to separate the first communication hole 411 from the second communication hole 412. This helps extend a flow distance of the cooling liquid between the first communication hole 411 and the second communication hole 412. The second heat dissipation plate flow channel 432 is the U-shaped flow channel, which can improve cooling efficiency of the series branch included in the second heat dissipation plate flow channel. In this embodiment of this application, the heat dissipation fins 441 and the flow guide fins 442 are distributed on the two sides of the first separation protrusion 421. This helps expand a coverage range of the heat dissipation fins 441 and the flow guide fins 442 in the second heat dissipation plate flow channel 432, so that the U-shaped second heat dissipation plate flow channel 432 can cooperate with the heat dissipation fins 441 and the flow guide fins 442. In an embodiment, some of the heat dissipation fins 441 are distributed on two sides of the second separation protrusion 422, and some of the flow guide fins 442 are distributed on two sides of the second separation protrusion 422.

In this embodiment of this application, the split flow channel 800 is close to the fourth communication hole 414 and far away from the second communication hole 412, and the second heat dissipation plate flow channel 432 is the U-shaped flow channel, so that a flow distance of the cooling liquid between the split flow channel 800 and the second communication hole 412 can be further extended, and a cooling range of the first liquid cooling plate 400 can be expanded.

In this embodiment of this application, the heat dissipation fins 441 and the flow guide fins 442 may be arranged at different locations on the first liquid cooling plate 400 based on functions of the heat dissipation fins 441 and the flow guide fins 442. In an embodiment, in the electrical components 300 distributed between the first liquid cooling plate 400 and the second liquid cooling plate 500 in the first direction A, a loss density of an electrical component 300 that overlaps a projection part of the heat dissipation fins 441 in the first direction A is higher than a loss density of another electrical component 300. In an embodiment, in the electrical components 300 distributed between the first liquid cooling plate 400 and the second liquid cooling plate 500 in the first direction A, a temperature resistance level of an electrical component 300 that overlaps a projection part of the heat dissipation fins 441 in the first direction A is lower than a temperature resistance level of another electrical component 300. In this embodiment of this application, both the loss density and the temperature resistance level can represent heat dissipation requirements of the electrical components 300. The heat dissipation fins 441 are arranged adjacent to the electrical components 300 with a high loss density and a low temperature resistance level, so that the heat dissipation fins 441 can be used to cool and dissipate heat for the electrical components 300 with a higher heat dissipation requirement. In an embodiment, an end face of the heat dissipation fin 441 in the first direction A may be of a circular shape, an elliptical shape, a square shape, or a rhombic shape. The circular and elliptical heat dissipation fins 441 are easy to process, and the square and rhombic heat dissipation fins 441 have better turbulence effect on the cooling liquid.

In an embodiment, the flow guide fin 442 is adjacent to a corner area of the first liquid cooling plate 400. In this embodiment of this application, the corner area is a turning point on the flow path of the cooling liquid, and a flow direction of the cooling liquid usually changes greatly in the corner area. If no flow guide fin 442 guides flow of the cooling liquid, a part of cooling liquid may accumulate in the corner area due to a slow flow speed in a redirection process, to form a flow dead area. This is not conducive to even distribution of the cooling liquid in the first liquid cooling plate 400. In this embodiment of this application, the flow guide fin 442 can forcibly make the cooling liquid flow in an extension direction of the flow guide fin 442, to improve heat dissipation efficiency of the cooling liquid. In an embodiment, an end face of the flow guide fin 442 in the first direction A may be of a linear shape, an arc shape, or a sickle shape, or a combination of the foregoing shapes.

Still refer to FIG. 3. In an embodiment, at least one of the flow guide fins 442 or the heat dissipation fins 441 on the two sides of the first separation protrusion 421 differs in at least one of a quantity, a shape, or an arrangement manner.

In this embodiment of this application, the heat dissipation fins 441 on the two sides of the first separation protrusion 421 differ in at least one of a quantity, a shape, or an arrangement manner. Alternatively, the flow guide fins 442 on the two sides of the first separation protrusion 421 differ in at least one of a quantity, a shape, or an arrangement manner. Alternatively, the heat dissipation fins 441 on the two sides of the first separation protrusion 421 differ in at least one of a quantity, a shape, or an arrangement manner, and the flow guide fins 442 on the two sides of the first separation protrusion 421 differ in at least one of a quantity, a shape, or an arrangement manner.

In this embodiment of this application, the second heat dissipation plate flow channel 432 is the U-shaped flow channel. That is, a flow path of the cooling liquid in the second heat dissipation plate flow channel 432 is approximately U-shaped, and temperatures and cooling effect of the cooling liquid at two ends of the U-shaped flow channel are different. In this embodiment of this application, adjusting layouts of the heat dissipation fins 441 and the flow guide fins 442 helps reduce a difference between heat dissipation efficiency of the cooling liquid at different locations in the second heat dissipation plate flow channel 432.

Still refer to FIG. 3 and FIG. 4. In an embodiment, the first liquid cooling plate 400 is integrated on a surface that is of the cover plate 100 and that is away from the accommodation groove 200 in the first direction A. The cover plate 100 includes a sealing plate 110. The sealing plate 110 is distributed on an outer side of the accommodation groove 200, and the sealing plate 110 is configured to cover the first liquid cooling plate 400.

In this embodiment of this application, the first liquid cooling plate 400 is integrated into the cover plate 100, to help enhance structural strength of the first liquid cooling plate 400. In addition, in this embodiment of this application, integration of the on-board charger 11 can be improved, which helps implement a lightweight design of the on-board charger 11 and optimize a layout of the powertrain 10.

In this embodiment of this application, the air in the accommodation groove 200 expands in volume after being heated, and the air tends to move upward to the cover plate 100. The first liquid cooling plate 400 is integrated into the cover plate 100, which facilitates heat exchange between the first liquid cooling plate 400 and the hot air in the accommodation groove 200. In addition, the first liquid cooling plate 400 does not occupy space in the accommodation groove 200, which helps optimize layouts of the plurality of electrical components 300 in the accommodation groove 200.

In an embodiment, both the heat dissipation fins 441 and the flow guide fins 442 protrude toward the sealing plate 110 in the first direction A, and both the heat dissipation fins 441 and the flow guide fins 442 are spaced from the sealing plate 110. In this embodiment of this application, the cooling liquid located between the heat dissipation fins 441 or the flow guide fins 442 can continue to flow through gaps between the heat dissipation fins 441 or the flow guide fins 442 and the sealing plate, thereby reducing a flow resistance of the cooling liquid.

In an embodiment, the first liquid cooling plate 400 includes a flow channel groove 451. An orientation of a groove opening of the flow channel groove 451 is away from the plurality of electrical components 300 of the on-board charger 11 in the first direction A. The flow channel groove 451 is configured to enclose the sealing plate 110. The first communication hole 411, the second communication hole 412, the third communication hole 413, the fourth communication hole 414, the first separation protrusion 421, the second separation protrusion 422, the heat dissipation fins 441, and the flow guide fins 442 are distributed at a groove bottom of the flow channel groove 451.

In this embodiment of this application, the groove opening of the flow channel groove 451 faces an outer side of the accommodation groove 200 in the first direction A, which helps reduce processing difficulty of the first liquid cooling plate 400, and further facilitates disassembly of the sealing plate 110 to repair the first liquid cooling plate 400, thereby reducing repair costs.

In an embodiment, the sealing plate 110 is connected to the groove opening of the flow channel groove 451 in a sealing manner. In this embodiment of this application, the cooling liquid does not leak, so that utilization and heat dissipation effect of the cooling liquid is enhanced.

Refer to FIG. 3 and FIG. 9. FIG. 9 is a partial sectional view of a cover plate 100 according to an embodiment of this application. In an embodiment, the first separation protrusion 421 and the second separation protrusion 422 are respectively in contact with the groove bottom of the flow channel groove 451 and the sealing plate 110 in the first direction A, and a length of the split flow channel 800 in the first direction A is equal to a distance between the groove bottom of the flow channel groove 451 and the sealing plate 110.

In this embodiment of this application, the first separation protrusion 421 and the second separation protrusion 422 are fastened by using the groove bottom of the flow channel groove 451 and the sealing plate 110, to help enhance structural strength of the first separation protrusion 421 and the second separation protrusion 422, and ensure that the first separation protrusion 421 and the second separation protrusion 422 stably play roles of flow split and flow guide.

In an embodiment, the first separation protrusion 421, the second separation protrusion 422, and the cover plate 100 are integrally formed. In this embodiment of this application, structural strength of the first separation protrusion 421 and the second separation protrusion 422 can be enhanced, so that the first separation protrusion 421 and the second separation protrusion 422 can stably split the cooling liquid.

In an embodiment, the cover plate 100 and at least one of the first separation protrusion 421 or the second separation protrusion 422 are of a split structure, and the at least one of the first separation protrusion 421 or the second separation protrusion 422 is detachably connected to the cover plate 100. In this embodiment of this application, assembly and disassembly of the first separation protrusion 421 and the second separation protrusion 422 are more flexible and convenient, and locations of the first separation protrusion 421 and the second separation protrusion 422 in the first liquid cooling plate 400 can be adjusted based on an actual requirement.

In an embodiment, the at least one of the first separation protrusion 421 or the second separation protrusion 422 may rotate relative to the groove bottom of the flow channel groove 451. In this embodiment of this application, a flow rate of the cooling liquid in the first liquid cooling plate 400 and the second liquid cooling plate 500 is adjusted by changing an area of the first heat dissipation plate flow channel 431 and an area of the second heat dissipation plate flow channel 432.

In an embodiment, the second separation protrusion 422 may extend or retract in a direction close to or away from the first separation protrusion 421. In an embodiment, the first separation protrusion 421 may extend or retract in a direction close to or away from the second separation protrusion 422. In this embodiment of this application, a flow rate of the cooling liquid in the first liquid cooling plate 400 and the second liquid cooling plate 500 is adjusted by changing an inner diameter of the split flow channel 800.

In an embodiment, the on-board charger 11 further includes a multi-way valve. The split flow channel 800 located between the first separation protrusion 421 and the second separation protrusion 422 is configured to accommodate the multi-way valve. The multi-way valve is configured to split cooling liquid from one of the first heat dissipation plate flow channel 431 or the second heat dissipation plate flow channel 432 into a plurality of tributaries.

In an embodiment, the first liquid cooling plate 400 is formed into the cover plate 100 through die casting. In an embodiment, the first separation protrusion 421, the second separation protrusion 422, the heat dissipation fins 441, the flow guide fins 442, and the groove bottom of the flow channel groove 451 are integrated through die casting. In this embodiment of this application, a die casting process is suitable for processing a complex structure. The first separation protrusion 421, the second separation protrusion 422, the heat dissipation fins 441, and the flow guide fins 442 are formed through die casting by using the die casting process, so that processing difficulty of the first liquid cooling plate 400 can be reduced.

In an embodiment, the second liquid cooling plate includes two sheet metal parts, the two sheet metal parts are stacked in the first direction, and edges of the two sheet metal parts are sealed through brazing. In this embodiment of this application, the second liquid cooling plate is manufactured by using a brazing process, to reduce costs and implement a lightweight design of the second liquid cooling plate.

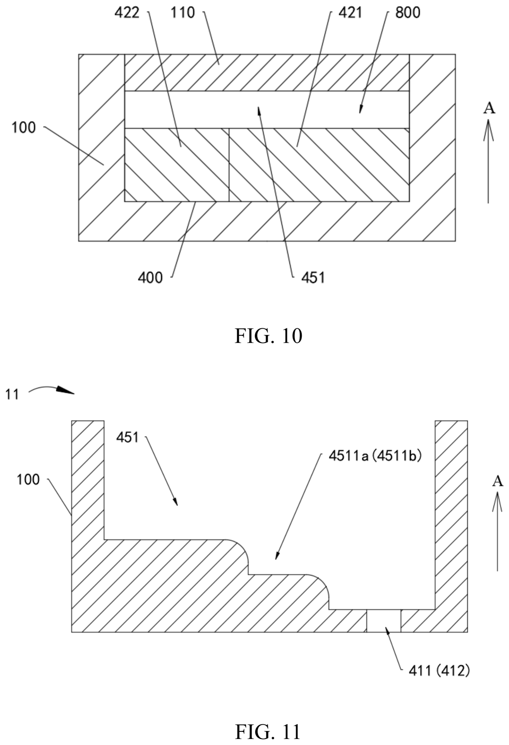

FIG. 10 is a partial sectional view of a cover plate 100 according to an embodiment of this application. In an embodiment, the first separation protrusion 421 and the second separation protrusion 422 are integrally formed. The first separation protrusion 421 and the second separation protrusion 422 are in contact with the groove bottom of the flow channel groove 451 in the first direction A, and the split flow channel 800 is distributed in a gap between the sealing plate 110, and the first separation protrusion 421 and the second separation protrusion 422 in the first direction A. A length of the split flow channel 800 in the first direction A is less than a distance between the groove bottom of the flow channel groove 451 and the sealing plate 110. In an embodiment, the first separation protrusion 421 and the second separation protrusion 422 are in contact with the sealing plate 110 in the first direction A, and the split flow channel 800 is distributed in a gap between the groove bottom of the flow channel groove 451, and the first separation protrusion 421 and the second separation protrusion 422 in the first direction A. A length of the split flow channel 800 in the first direction A is less than a distance between the groove bottom of the flow channel groove 451 and the sealing plate 110.

In this embodiment of this application, the split flow channel 800 is formed by using the gap between the first separation protrusion 421 and the second separation protrusion 422, and the sealing plate 110 or the groove bottom of the flow channel groove 451, to adjust a flow rate of the cooling liquid in the first liquid cooling plate 400 and the second liquid cooling plate 500.

In an embodiment, the first separation protrusion 421, the second separation protrusion 422, and the sealing plate 110 are integrally formed, and the first separation protrusion 421 and the second separation protrusion 422 are distributed on a surface that is of the sealing plate 110 and that faces the groove bottom of the flow channel groove 451 in the first direction A. In this embodiment of this application, structural strength of the first separation protrusion 421 and the second separation protrusion 422 can be enhanced.

Refer to FIG. 3 and FIG. 11. FIG. 11 is a partial sectional view of a cover plate 100 according to an embodiment of this application.

In an embodiment, the groove bottom of the flow channel groove 451 includes one buffer groove 4511. The buffer groove 4511 is recessed toward the accommodation groove 200 in the first direction A, and the first communication hole 411 penetrates a groove bottom of the buffer groove 4511. An area of a groove opening of the buffer groove 4511 is greater than an area of the groove bottom of the buffer groove 4511. A groove peripheral wall of the buffer groove 4511 tilts from the groove opening of the buffer groove 4511 to the groove bottom of the buffer groove 4511. A cross section of the groove peripheral wall of the buffer groove 4511 in the first direction A is of a linear shape, an arc shape, or a stepped shape.

In this embodiment of this application, for ease of description, the buffer groove 4511 is denoted as a buffer groove 4511a. Because the opening of the first communication hole 411 faces the accommodation groove 200 in the first direction A, the buffer groove 4511a is recessed toward the accommodation groove 200 in the first direction A, and the first communication hole 411 penetrates the groove bottom of the buffer groove 4511a. In this way, the cooling liquid can flow into the first liquid cooling plate 400 through the first communication hole 411 more conveniently, to shorten a path through which the cooling liquid flows into the first communication hole 411. In this case, there is a height difference between the first communication hole 411 and a part of the groove bottom of the flow channel groove 451 other than the buffer groove 4511a. In this embodiment of this application, the groove peripheral wall of the buffer groove 4511a is used to transition and buffer the cooling liquid, to reduce a flow resistance loss caused by the height difference.

Still refer to FIG. 3 and FIG. 11. In an embodiment, the groove bottom of the flow channel groove 451 further includes another buffer groove 4511. The another buffer groove 4511 is recessed toward the accommodation groove 200 in the first direction A, and the second communication hole 412 penetrates a groove bottom of the another buffer groove 4511. An area of a groove opening of the another buffer groove 4511 is greater than an area of the groove bottom of the another buffer groove 4511. A groove peripheral wall of the another buffer groove 4511 tilts from the groove opening of the another buffer groove 4511 to the groove bottom of the another buffer groove 4511. A cross section of the groove peripheral wall of the another buffer groove 4511 in the first direction A is of a linear shape, an arc shape, or a stepped shape.

In this embodiment of this application, for ease of description, the another buffer groove 4511 is denoted as a buffer groove 4511b. Because the opening of the second communication hole 412 faces the accommodation groove 200 in the first direction A, the buffer groove 4511b is recessed toward the accommodation groove 200 in the first direction A, and the second communication hole 412 penetrates the groove bottom of the buffer groove 4511b. In this way, the cooling liquid can flow into an external cooling system or an internal cooling channel through the second communication hole 412 more conveniently. In this case, there is a height difference between the second communication hole 412 and a part of the groove bottom of the flow channel groove 451 other than the buffer groove 4511a and the buffer groove 4511b. In this embodiment of this application, the groove peripheral wall of the buffer groove 4511b is used to transition and buffer the cooling liquid, to reduce a flow resistance loss caused by the height difference.

Still refer to FIG. 4. In an embodiment, in a second direction B, a length of the first liquid cooling plate 400 is greater than a length of the second liquid cooling plate 500, and the second direction B is perpendicular to the first direction A.

In this embodiment of this application, the second direction B is perpendicular to an arrangement direction of the first liquid cooling plate 400 and the second liquid cooling plate 500, and the length of the first liquid cooling plate 400 in the second direction B is greater than the length of the second liquid cooling plate 500 in the second direction B. This can increase a contact area between the first liquid cooling plate 400 and the hot air, to help reduce a temperature in the accommodation groove 200. In addition, the first liquid cooling plate 400 is integrated into the cover plate 100. Extending the length of the first liquid cooling plate 400 in the second direction B does not interfere with the layouts of the electrical components 300 in the accommodation groove 200. The second liquid cooling plate 500 is located in the accommodation groove 200. If the length of the second liquid cooling plate 500 in the second direction B is excessively long, clearance with the electrical component 300 may need to be considered. In an embodiment, the second direction B is a length direction or a width direction of the cover plate 100. In an embodiment, an area of the first liquid cooling plate 400 is greater than an area of the second liquid cooling plate 500.

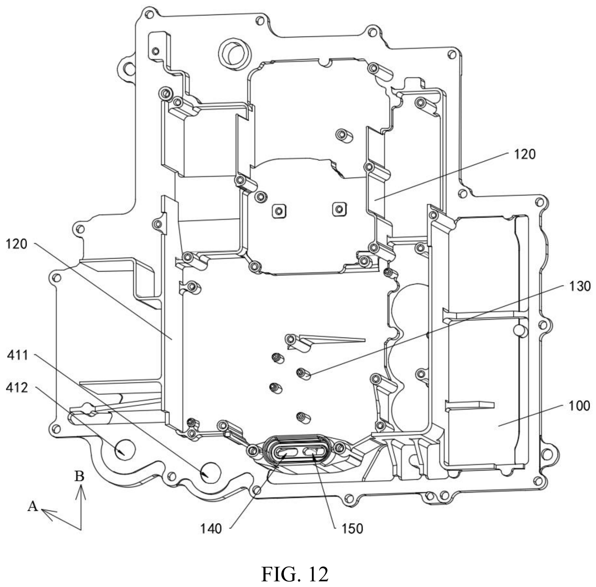

Refer to FIG. 4 and FIG. 12. FIG. 12 is a diagram of a cover plate 100 according to an embodiment of this application. In an embodiment, a surface that is of the cover plate 100 and that faces the accommodation groove 200 in the first direction A is used to fasten the circuit board 301, and two opposite surfaces of the cover plate 100 and the circuit board 301 in the first direction A are used to fasten the electrical components 300.

The surface that is of the cover plate 100 and that faces the accommodation groove 200 in the first direction A includes a plurality of shield protrusions 120. The plurality of shield protrusions 120 protrude toward the groove bottom of the accommodation groove 200 in the first direction A, and each shield protrusion 120 is configured to be embedded in a gap between two adjacent electrical components 300.

In this embodiment of this application, the first liquid cooling plate 400 is integrated on the surface that is of the cover plate 100 and that is away from the accommodation groove 200, and the surface that is of the cover plate 100 and that faces the accommodation groove 200 is used to fasten the electrical components 300. This can shorten a heat transmission path between the electrical component 300 and the first liquid cooling plate 400 without occupying space of the accommodation groove 200 by the first liquid cooling plate 400, and can further reduce a risk of cooling liquid leakage. In this embodiment of this application, each shield protrusion 120 of the cover plate 100 is embedded between the two adjacent electrical components 300, so that the electrical components 300 on two sides of the shield protrusion 120 can be shielded electromagnetically, thereby improving electromagnetic compatibility.

In an embodiment, the surface that is of the cover plate 100 and that faces the accommodation groove 200 in the first direction A includes a plurality of fastening protrusions 130. The plurality of fastening protrusions 130 protrude from the groove bottom of the accommodation groove 200 in the first direction A, and the fastening protrusions 130 are configured to fasten the electrical components 300. In this embodiment of this application, the fastening protrusion 130 is a part of the cover plate 100, and that the fastening protrusions 130 are fastened to the electrical components 300 is equivalent to that the cover plate 100 is in direct contact with the electrical components. This helps improve heat exchange efficiency.

In an embodiment, a projection of at least one electrical component 300 in the first direction A overlaps a projection of the first liquid cooling plate 400.

In an embodiment, the plurality of electrical components 300 may include a magnetic component 310 and a capacitor 320. The magnetic component 310 and the capacitor 320 are arranged between the cover plate 100 and the circuit board 301 in the first direction A. In this embodiment of this application, the first liquid cooling plate 400 integrated into the cover plate 100 includes a series branch, and the series branch has a low thermal resistance, to enhance effect of cooling the magnetic component 310 and the capacitor 320 by the first liquid cooling plate 400. In an embodiment, the magnetic component 310 includes a transformer and an inductor.

In an embodiment, as shown in FIG. 4, the plurality of electrical components 300 may further include a power switching transistor 330. A surface that is of the circuit board 301 and that faces the second liquid cooling plate 500 in the first direction A is used to fasten the power switching transistors 330. The power switching transistors 330 are distributed between the circuit board 301 and the second liquid cooling plate 500. In this embodiment of this application, the cooling liquid in the second liquid cooling plate 500 can dissipate heat for the power switching transistor 330. The power switching transistor 330 is configured to participate in a power conversion process of the on-board charger 11. The power switching transistor 330 is more likely to be affected by vibration than the magnetic component 310 and the capacitor 320. A distance between the power switching transistor 330 and the cover plate 100 in the first direction A is greater than a distance between the cover plate 100 and each of the magnetic component 310 and the capacitor 320, and the power switching transistor 330s are not distributed on the surface that is of the cover plate 100 and that faces the accommodation groove 200. In this way, the cover plate 100 cannot directly transfer external vibration to the power switching transistors 330, to ensure normal operation of the power switching transistor 330, and reduce heat generation.

Still refer to FIG. 3 and FIG. 12. In an embodiment, the surface that is of the cover plate 100 and that faces the accommodation groove 200 in the first direction A further includes a first communication port 140 and a second communication port 150. A surface that is of the second liquid cooling plate 500 and that faces the cover plate 100 in the first direction A is used to fasten the first communication port 140 and the second communication port 150. The first communication port 140 and the second communication port 150 are distributed on an inner side of the accommodation groove 200. The first communication port 140 is configured for communication of the third communication hole 413 and an inlet of a flow channel of the second liquid cooling plate 500, and the second communication port 150 is configured for communication of the fourth communication hole 414 and an outlet of a flow channel of the second liquid cooling plate 500.

In this embodiment of this application, the first communication port 140 and the second communication port 150 are configured for communication of the first liquid cooling plate 400 and the second liquid cooling plate 500. The first communication port 140 and the second communication port 150 are integrated into the cover plate 100 and are fastened to the second liquid cooling plate 500, so that structural stability of the first communication port 140 and the second communication port 150 can be enhanced, and the cooling liquid does not leak in a process of flowing between the first liquid cooling plate 400 and the second liquid cooling plate 500.

In this embodiment of this application, the first communication port 140 and the second communication port 150 are located in the accommodation groove 200, and the first communication port 140 and the second communication port 150 are spaced from a groove wall of the accommodation groove 200. If the first communication port 140 and the second communication port 150 are integrated into the groove wall of the accommodation groove 200, an overall thickness of the groove wall is increased, which is not conducive to the lightweight design of the on-board charger 11, and increases processing difficulty and costs of the accommodation groove 200. In this embodiment of this application, the accommodation groove 200 and both the first communication port 140 and the second communication port 150 are of a split structure, so that negative impact on processing of the accommodation groove 200 can be avoided.

Refer to FIG. 3 and FIG. 4. In an embodiment, the groove wall of the accommodation groove 200 includes a first groove wall section 210 and a second groove wall section 220. The first groove wall section 210 and the second groove wall section 220 are arranged opposite to each other in the second direction B, and the second direction B is perpendicular to the first direction A.

A distance between the first groove wall section 210 and each of the first communication hole 411, the second communication hole 412, an outlet of the housing liquid inlet flow channel 600, and an inlet of the housing liquid outlet flow channel 700 is less than a distance between the second groove wall section 220 and each of the first communication hole 411, the second communication hole 412, the outlet of the housing liquid inlet flow channel 600, and the inlet of the housing liquid outlet flow channel 700.

In this embodiment of this application, the first communication hole 411 and the second communication hole 412 are adjacent to the first groove wall section 210 of the accommodation groove 200, so that the first communication hole 411 and the second communication hole 412 are compactly arranged. The first communication hole 411 and the second communication hole 412 are adjacent to the first groove wall section 210 of the accommodation groove 200, so that the first communication hole 411 and the second communication hole 412 communicate with the housing liquid inlet flow channel 600 and the housing liquid outlet flow channel 700 that are distributed on the outer side of the accommodation groove 200.

Still refer to FIG. 5. In an embodiment, the outlet of the housing liquid inlet flow channel 600 is configured to communicate with the first communication hole 411, and an orientation of the outlet of the housing liquid inlet flow channel 600 is the same as an orientation of the groove opening of the accommodation groove 200.

The surface that is of the cover plate 100 and that faces the accommodation groove 200 in the first direction A is used to fasten a flow channel communication component 900. The flow channel communication component 900 is distributed on the outer side of the accommodation groove 200. One end of the flow channel communication component 900 is configured to cover the first communication hole 411, and the other end of the flow channel communication component 900 is configured to be embedded in the outlet of the housing liquid inlet flow channel 600.

In this embodiment of this application, the flow channel communication component 900 is configured for communication of the outlet of the housing liquid inlet flow channel 600 and the first communication hole 411 of the first liquid cooling plate 400. Both the housing liquid inlet flow channel 600 and the flow channel communication component 900 are distributed on the outer side of the accommodation groove 200, to facilitate checking of communication. The one end of the flow channel communication component 900 covers the first communication hole 411, and the other end of the flow channel communication component 900 is embedded in the outlet of the housing liquid inlet flow channel 600, so that the cooling liquid does not leak at a joint between the flow channel communication component 900, and the housing liquid inlet flow channel 600 and the cover plate 100.

Still refer to FIG. 4. In an embodiment, the inlet of the housing liquid outlet flow channel 700 is configured to receive the cooling liquid output by the first liquid cooling plate 400, and an outlet of the housing liquid outlet flow channel 700 is configured to drain the cooling liquid from the on-board charger 11.

The inlet of the housing liquid outlet flow channel 700 is distributed on a groove wall of the accommodation groove 200, and the outlet of the housing liquid outlet flow channel 700 is distributed on the outer side of the accommodation groove 200. An orientation of the inlet of the housing liquid outlet flow channel 700 is opposite to an orientation of the second communication hole 412, and the second communication hole 412 is embedded in the inlet of the housing liquid outlet flow channel 700. An orientation of the outlet of the housing liquid outlet flow channel 700 intersects an orientation of the inlet of the housing liquid outlet flow channel 700.

In this embodiment of this application, the first liquid cooling plate 400 is integrated into the cover plate 100, and the cover plate 100 and the accommodation groove 200 are stacked in the first direction A. The inlet of the housing liquid outlet flow channel 700 is arranged on the groove wall of the accommodation groove 200, and the orientation of the inlet of the housing liquid outlet flow channel 700 is opposite to the orientation of the second communication hole 412, to help shorten a transmission distance of the cooling liquid between the second communication hole 412 and the housing liquid outlet flow channel 700. The outlet of the housing liquid outlet flow channel 700 is arranged on the outer side of the accommodation groove 200, and the second communication hole 412 is embedded in the inlet of the housing liquid outlet flow channel 700, to prevent the cooling liquid with a high temperature from leaking into the accommodation groove 200. The orientation of the outlet of the housing liquid outlet flow channel 700 intersects the orientation of the inlet of the housing liquid outlet flow channel 700, to change an outflow direction of the cooling liquid from the outlet of the housing liquid outlet flow channel 700.

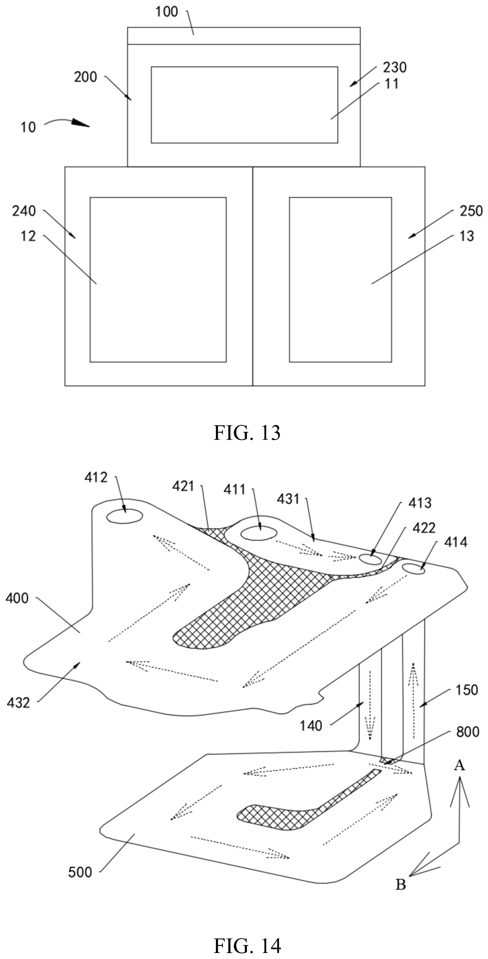

FIG. 13 is a diagram of a powertrain 10 according to an embodiment of this application. It should be noted that FIG. 5 shows only an example location relationship between the accommodation groove 200 and the on-board charger 11, the drive motor 12, and the reducer 13, and does not represent specific structures and sizes of the accommodation groove 200, the on-board charger 11, the drive motor 12, and the reducer 13.

In an embodiment, the accommodation groove 200 of the on-board charger 11 is an integrated housing. The accommodation groove 200 includes a power supply cavity 230, a motor cavity 240, and a reducer cavity 250. The power supply cavity 230 is configured to accommodate the on-board charger 11, the motor cavity 240 is configured to accommodate the drive motor 12, and the reducer cavity 250 is configured to accommodate the reducer 13.

In this embodiment of this application, the on-board charger 11 is used in the powertrain 10, and the accommodation groove 200 of the on-board charger 11 may be used to accommodate the on-board charger 11 and the drive motor 12, and the reducer 13 of the powertrain 10. This helps improve integration of the powertrain 10 and reduce a volume of the powertrain 10. The accommodation groove 200 is the integrated housing, and a bottom wall of the power supply cavity 230 of the accommodation groove 200 needs to be shared with at least one of the motor cavity 240 or the reducer cavity 250. In this case, the first liquid cooling plate and the second liquid cooling plate in embodiments of this application are far away from the groove bottom of the accommodation groove, so that processing difficulty of the first liquid cooling plate can be reduced, and the first liquid cooling plate can be easily connected to the external cooling system through the first communication hole and the second communication hole. In addition, the drive motor 12 and the reducer 13 rotate at a high speed in an operating process. If the first liquid cooling plate is integrated into the bottom wall of the power supply cavity 230, because the bottom wall is close to the drive motor 12 and the reducer 13, flow of the cooling liquid in the first liquid cooling plate may be interfered with by the drive motor 12 and the reducer 13.

Still refer to FIG. 3 to FIG. 6. An embodiment of this application further provides an on-board charger 11. An electrical component 300 of the on-board charger 11 is configured to charge and discharge a power battery 20 of an electric vehicle 1. A housing of the on-board charger 11 includes a cover plate 100 and an accommodation groove 200. The cover plate 100 is configured to enclose the accommodation groove 200 in a first direction A, and the accommodation groove 200 is configured to accommodate the electrical component 300 of the on-board charger 11.

A three-dimensional liquid cooling loop of the on-board charger 11 includes a first liquid cooling plate 400, a second liquid cooling plate 500, a split flow channel 800, a housing liquid inlet flow channel 600, and a housing liquid outlet flow channel 700. The first liquid cooling plate 400 and the second liquid cooling plate 500 are stacked in the first direction A, and the electrical component 300 of the on-board charger 11 is arranged between the first liquid cooling plate 400 and the second liquid cooling plate 500.

The first liquid cooling plate 400 includes a first separation protrusion 421, a second separation protrusion 422, a first communication hole 411, a second communication hole 412, a third communication hole 413, and a fourth communication hole 414. The first separation protrusion 421 and the second separation protrusion 422 are configured to separate a flow channel of the first liquid cooling plate 400 into a first heat dissipation plate flow channel 431 and a second heat dissipation plate flow channel 432. The split flow channel 800 is configured for communication of the first heat dissipation plate flow channel 431 and the second heat dissipation plate flow channel 432. The first separation protrusion 421 is distributed between the first communication hole 411 and the second communication hole 412, and the second separation protrusion 422 is distributed between the third communication hole 413 and the fourth communication hole 414.

The first communication hole 411 and the third communication hole 413 are distributed on the first heat dissipation plate flow channel 431, and the second communication hole 412 and the fourth communication hole 414 are distributed on the second heat dissipation plate flow channel 432. The first heat dissipation plate flow channel 431 is configured to receive cooling liquid from the housing liquid inlet flow channel 600 through the first communication hole 411, and the first heat dissipation plate flow channel 431 is configured to deliver the cooling liquid to an inlet of a flow channel of the second liquid cooling plate 500 through the third communication hole 413. The second heat dissipation plate flow channel 432 is configured to receive the cooling liquid from an outlet of the flow channel of the second liquid cooling plate 500 through the fourth communication hole 414, the second heat dissipation plate flow channel 432 is configured to receive the cooling liquid from the first heat dissipation plate flow channel 431 through the split flow channel 800, and the second heat dissipation plate flow channel 432 is configured to deliver the cooling liquid to the housing liquid outlet flow channel 700 through the second communication hole 412.

In this embodiment of this application, some electrical components 300 have a high loss density, and generate a large amount of heat in an operating process. generating heat by the electrical components 300 with the high loss density reduces operating efficiency of the electrical components 300, and adversely affects the electrical component 300 with a low temperature resistance level. The loss density is an energy loss density in the operating process, and the temperature resistance level is a maximum allowable operating temperature.

To resolve the foregoing problems, in embodiments of this application, the electrical component 300 is arranged between the first liquid cooling plate 400 and the second liquid cooling plate 500 in the first direction A. The cooling liquid in the first liquid cooling plate 400 and the second liquid cooling plate 500 can cool the electrical component 300 from different angles, to cool the electrical component 300 in a three-dimensional manner. This helps expand a cooling range of the cooling liquid in the electrical component 300, and avoid insufficient local cooling.

In this embodiment of this application, the housing liquid inlet flow channel 600 and the housing liquid outlet flow channel 700 are respectively configured to implement input and output of the cooling liquid in the on-board charger 11, indicating that the cooling liquid in the first liquid cooling plate 400 and the second liquid cooling plate 500 is in a continuous flow and update state. This helps enhance effect of cooling the electrical components 300 by the first liquid cooling plate 400 and the second liquid cooling plate 500.

In this embodiment of this application, the first liquid cooling plate 400 and the second liquid cooling plate 500 communicate with each other through the third communication hole 413 and the fourth communication hole 414. Both the first liquid cooling plate 400 and the second liquid cooling plate 500 communicate with the housing liquid inlet flow channel 600 through the first communication hole 411 and communicate with the housing liquid outlet flow channel 700 through the second communication hole 412. The first communication hole 411, the second communication hole 412, the third communication hole 413, and the fourth communication hole 414 are all distributed in the first liquid cooling plate 400, which helps simplify a structure of the three-dimensional liquid cooling loop of the on-board charger 11. In addition, a cooling manner of series-parallel hybrid connection between the first liquid cooling plate 400 and the second liquid cooling plate 500 is designed based on heat dissipation requirements of the electrical components 300, to improve practicality of the first liquid cooling plate 400 and the second liquid cooling plate 500.

In this embodiment of this application, the first separation protrusion 421 and the second separation protrusion 422 are configured to separate the first liquid cooling plate 400 into the first heat dissipation plate flow channel 431 and the second heat dissipation plate flow channel 432. In this embodiment of this application, a series-parallel hybrid connection design is implemented between the first liquid cooling plate 400 and the second liquid cooling plate 500 by using the first separation protrusion 421, the second separation protrusion 422, and the split flow channel 800. Specifically, as shown in FIG. 6, after flowing into the first heat dissipation plate flow channel 431 through the first communication hole 411, the cooling liquid is split into two paths of cooling liquid at the split flow channel 800. One path of cooling liquid flows into the second liquid cooling plate 500, and the other path of cooling liquid flows into the second heat dissipation plate flow channel 432. Because the second liquid cooling plate 500 communicates with the first liquid cooling plate 400, the cooling liquid on one channel finally flows back to the second heat dissipation plate flow channel 432 through the second liquid cooling plate 500.

In this embodiment of this application, series-parallel hybrid connection is implemented between the first liquid cooling plate 400 and the second liquid cooling plate 500, so that advantages of the series branch and the parallel branches can be comprehensively utilized. A flow rate of the cooling liquid in the series branch is high, and the series branch has an advantage of a small thermal resistance. The second heat dissipation plate flow channel 432 of the first liquid cooling plate 400 includes the series branch, which can prevent a temperature of the cooling liquid in the first liquid cooling plate 400 from increasing excessively fast, thereby helping improve cooling efficiency of the first liquid cooling plate 400. A flow rate of the cooling liquid in the parallel branch is low, and the parallel branch has an advantage of a small flow resistance. The second liquid cooling plate 500 needs to communicate with the housing liquid inlet flow channel 600 and the housing liquid outlet flow channel 700 through the first liquid cooling plate 400. The second liquid cooling plate 500 includes one parallel branch, which helps reduce a flow resistance loss of the cooling liquid between the first liquid cooling plate 400 and the second liquid cooling plate 500.

In this embodiment of this application, the first separation protrusion 421 and the second separation protrusion 422 separates the first liquid cooling plate 400 into the first heat dissipation plate flow channel 431 and the second heat dissipation plate flow channel 432. The first heat dissipation plate flow channel 431 and the second heat dissipation plate flow channel 432 communicate with each other through the split flow channel 800, so that the cooling liquid can flow in the pre-designed series-parallel hybrid connection manner. If the first separation protrusion 421 and the second separation protrusion 422 do not separate the first heat dissipation plate flow channel 431 from the second heat dissipation plate flow channel 432, in other words, there is no obvious boundary between the first heat dissipation plate flow channel 431 and the second heat dissipation plate flow channel 432, a flow path of the cooling liquid may be chaotic, and consequently, it is difficult to comprehensively exert advantages of the series branch and the parallel branch.

Still refer to FIG. 6 to FIG. 8. In an embodiment, the split flow channel 800 is distributed in a gap between the first separation protrusion 421 and the second separation protrusion 422.

In this embodiment of this application, the split flow channel 800 is configured to directly communicate the first heat dissipation plate flow channel 431 with the second heat dissipation plate flow channel 432. After flowing into the first heat dissipation plate flow channel 431 through the first communication hole 411, the cooling liquid is split into two paths of cooling liquid at the split flow channel 800. One path of cooling liquid flows into the second heat dissipation plate flow channel 432 and the second communication hole 412 in sequence through the split flow channel 800, and the other path of cooling liquid also flows into the second heat dissipation plate flow channel 432 through the third communication hole 413, the second liquid cooling plate 500, and the fourth communication hole 414 in sequence. The cooling liquid flows into the split flow channel 800 through the first communication hole 411 and into the fourth communication hole 414 through the first communication hole 411 to form two parallel branches; and the cooling liquid in the two parallel branches converges in the second heat dissipation plate flow channel 432 and flows into the second communication hole 412 to form a series branch, so as to implement a cooling manner in which the first liquid cooling plate 400 and the second liquid cooling plate 500 are first connected in parallel and then connected in series. In this embodiment of this application, the split flow channel 800 is integrated into the first liquid cooling plate 400, which helps simplify an overall structure of the three-dimensional liquid cooling loop of the on-board charger 11 while implementing the series-parallel connection design.

As shown in FIG. 7, in an embodiment, the first communication hole 411 and the second communication hole 412 are interchangeable relative to the first heat dissipation plate flow channel 431 and the second heat dissipation plate flow channel 432 in terms of locations. To be specific, the first communication hole 411 and the third communication hole 413 are configured to communicate with the second heat dissipation plate flow channel 432, and the second communication hole 412 and the fourth communication hole 414 are configured to communicate with the first heat dissipation plate flow channel 431. The third communication hole 413 and the fourth communication hole 414 are respectively configured to communicate with an inlet and an outlet of the second liquid cooling plate 500. Therefore, locations of the third communication hole 413 and the fourth communication hole 414 change with locations of the first communication hole 411 and the second communication hole 412. In this embodiment of this application, after flowing into the second heat dissipation plate flow channel 432 through the first communication hole 411, the cooling liquid is split into two paths of cooling liquid at the split flow channel 800. One path of cooling liquid flows into the first heat dissipation plate flow channel 431 and the second communication hole 412 in sequence through the split flow channel 800, and the other path of cooling liquid also flows into the first heat dissipation plate flow channel 431 and the second communication hole 412 in sequence through the third communication hole 413, the second liquid cooling plate 500, and the fourth communication hole 414 in sequence. In this case, a cooling manner in which the first liquid cooling plate 400 and the second liquid cooling plate 500 are first connected in series and then connected in parallel is implemented.

As shown in FIG. 8, in an embodiment, a cooling manner in which the first liquid cooling plate 400 and the second liquid cooling plate 500 are connected in series in the front and rear and connected in parallel in the middle may alternatively be implemented by changing distances between the third communication hole 413 and the fourth communication hole 414, and the split flow channel 800, the first communication hole 411, and the second communication hole 412, and shapes of the first separation protrusion 421 and the second separation protrusion 422.

FIG. 14 is a partial view of an on-board charger 11 according to an embodiment of this application. In an embodiment, the split flow channel 800 is distributed between the inlet of the flow channel of the second liquid cooling plate 500 and the outlet of the flow channel of the second liquid cooling plate 500. An inlet of the split flow channel 800 is configured to communicate with the first heat dissipation plate flow channel 431 through the inlet of the flow channel of the second liquid cooling plate 500, and an outlet of the split flow channel 800 is configured to communicate with the second heat dissipation plate flow channel 432 through the outlet of the flow channel of the second liquid cooling plate 500.

In this embodiment of this application, in comparison with FIG. 6, a location of the split flow channel 800 in FIG. 14 changes. The cooling liquid flows through the first heat dissipation plate flow channel 431 and the inlet of the second liquid cooling plate 500 in sequence from the first communication hole 411, and is split into two paths of cooling liquid at the split flow channel 800. One path of cooling liquid flows into the fourth communication hole 414 and the second heat dissipation plate flow channel 432 in sequence through the split flow channel 800, and the other path of cooling liquid also flows into the second heat dissipation plate flow channel 432 through the flow channel of the second liquid cooling plate 500. In this embodiment of this application, a range of the series branch extends from the second heat dissipation plate flow channel 432 to the second liquid cooling plate 500, which helps improve efficiency of cooling the electrical components 300 by the second liquid cooling plate 500.

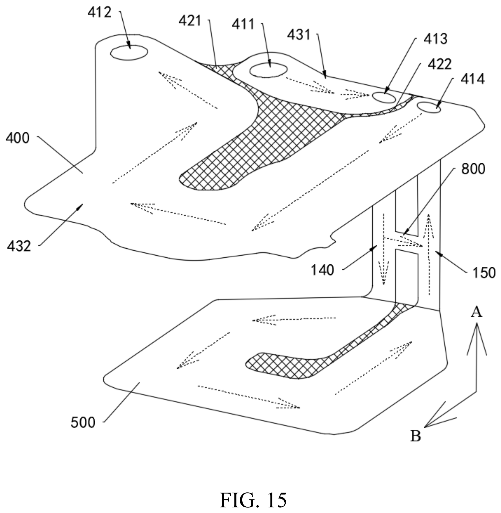

FIG. 15 is a partial view of an on-board charger 11 according to an embodiment of this application. In an embodiment, a surface that is of the first liquid cooling plate 400 and that faces the second liquid cooling plate 500 in the first direction A further includes a first communication port 140 and a second communication port 150. A surface that is of the second liquid cooling plate 500 and that faces the first liquid cooling plate 400 in the first direction A is used to fasten the first communication port 140 and the second communication port 150. The first communication port 140 is configured for communication of the third communication hole 413 and the inlet of the flow channel of the second liquid cooling plate 500, and the second communication port 150 is configured for communication of the fourth communication hole 414 and the outlet of the flow channel of the second liquid cooling plate 500.

The split flow channel 800 is distributed between the first communication port 140 and the second communication port 150. An inlet of the split flow channel 800 is configured to communicate with the first heat dissipation plate flow channel 431 through the first communication port 140, and an outlet of the split flow channel 800 is configured to communicate with the second heat dissipation plate flow channel 432 through the second communication port 150.

In this embodiment of this application, the first communication port 140 and the second communication port 150 are configured for communication of the first liquid cooling plate 400 and the second liquid cooling plate 500. The first communication port 140 and the second communication port 150 are integrated into the first liquid cooling plate 400 and are fastened to the second liquid cooling plate 500, so that structural stability of the first communication port 140 and the second communication port 150 can be enhanced, and the cooling liquid does not leak in a process of flowing between the first liquid cooling plate 400 and the second liquid cooling plate 500.

In this embodiment of this application, the split flow channel 800 is distributed between the first communication port 140 and the second communication port 150, and the split flow channel 800 is arranged between the first liquid cooling plate 400 and the second liquid cooling plate 500 in the first direction A. This can implement three-sided heat dissipation for the electrical components 300. A part of the second communication port 150 is configured to form a series branch, which helps improve efficiency of cooling the electrical components 300 through the second communication port 150.

In this embodiment of this application, the three-dimensional liquid cooling loop of the on-board charger may include a plurality of split flow channels, and the plurality of split flow channels are arranged at different locations based on actual heat dissipation requirements of the electrical components. In an embodiment, at least one split flow channel is distributed in a gap between the first separation protrusion and the second separation protrusion, and at least one split flow channel is distributed between the inlet of the flow channel of the second liquid cooling plate and the outlet of the flow channel of the second liquid cooling plate.

In an embodiment, at least one split flow channel is distributed in a gap between the first separation protrusion and the second separation protrusion, and at least one split flow channel is distributed between the first communication port and the second communication port.

In an embodiment, at least one split flow channel is distributed between the inlet of the flow channel of the second liquid cooling plate and the outlet of the flow channel of the second liquid cooling plate, and at least one split flow channel is distributed between the first communication port and the second communication port.

In an embodiment, at least one split flow channel is distributed in a gap between the first separation protrusion and the second separation protrusion, at least one split flow channel is distributed between the inlet of the flow channel of the second liquid cooling plate and the outlet of the flow channel of the second liquid cooling plate, and at least one split flow channel is distributed between the first communication port and the second communication port.

It should be noted that FIG. 14 and FIG. 15 show only examples of the serial-parallel hybrid connection manners of the first liquid cooling plate 400 and the second liquid cooling plate 500, and dashed arrows indicate only a movement trend of the cooling liquid, and does not indicate that the cooling liquid can flow only along the dashed arrows.

Still refer to FIG. 3 and FIG. 4. In an embodiment, the first liquid cooling plate 400 further includes a plurality of heat dissipation fins 441 and a plurality of flow guide fins 442.

The first separation protrusion 421 is configured to separate the first communication hole 411 from the second communication hole 412. The plurality of heat dissipation fins 441 are distributed on two sides of the first separation protrusion 421, and the plurality of flow guide fins 442 are distributed on two sides of the first separation protrusion 421. A length of each flow guide fin 442 is greater than a length of each heat dissipation fin 441, and a gap between two adjacent heat dissipation fins 441 is less than a gap between two adjacent flow guide fins 442.

In this embodiment of this application, the length of the heat dissipation fin 441 is less than the length of the flow guide fin 442, and the heat dissipation fins 441 are more closely arranged than the flow guide fins 442. Therefore, interaction between the cooling liquid and the heat dissipation fins 441 is stronger, and the heat dissipation fins 441 can cause turbulence to the cooling liquid, thereby enhancing heat dissipation effect. The length of the flow guide fin 442 is greater than the length of the heat dissipation fin, so that the cooling liquid flows in an extension direction of the flow guide fin 442. The flow guide fin 442 can guide a flow direction of the cooling liquid, to implement even distribution of cooling liquid flow. Arrangement tightness of the flow guide fins 442 is less than arrangement tightness of the heat dissipation fins 441, which helps reduce a flow resistance of the cooling liquid. The plurality of heat dissipation fins 441 and the plurality of flow guide fins 442 are integrated into the first liquid cooling plate 400, which helps enhance heat dissipation effect of the first liquid cooling plate 400.

In this embodiment of this application, the first separation protrusion 421 is configured to separate the first communication hole 411 from the second communication hole 412, so that the cooling liquid does not directly flow into the second communication hole through the first communication hole 411. The heat dissipation fins 441 and the flow guide fins 442 are distributed on the two sides of the first separation protrusion 421, so that the first heat dissipation plate flow channel 431 and the second heat dissipation plate flow channel 432 can cooperate with the heat dissipation fins 441 and the flow guide fins 442. In an embodiment, some heat dissipation fins 441 and some flow guide fins 442 are also distributed on two sides of the second separation protrusion 422.

In this embodiment of this application, the heat dissipation fins 441 and the flow guide fins 442 may be arranged at different locations on the first liquid cooling plate 400 based on functions of the heat dissipation fins 441 and the flow guide fins 442. In an embodiment, in the electrical components 300 distributed between the first liquid cooling plate 400 and the second liquid cooling plate 500 in the first direction A, a loss density of an electrical component 300 that overlaps a projection part of the heat dissipation fins 441 in the first direction A is higher than a loss density of another electrical component 300. In an embodiment, in the electrical components 300 distributed between the first liquid cooling plate 400 and the second liquid cooling plate 500 in the first direction A, a temperature resistance level of an electrical component 300 that overlaps a projection part of the heat dissipation fins 441 in the first direction A is lower than a temperature resistance level of another electrical component 300. In this embodiment of this application, both the loss density and the temperature resistance level can represent heat dissipation requirements of the electrical components 300. The heat dissipation fins 441 are arranged adjacent to the electrical components 300 with a high loss density and a low temperature resistance level, so that the heat dissipation fins 441 can be used to cool and dissipate heat for the electrical components 300 with a higher heat dissipation requirement. In an embodiment, an end face of the heat dissipation fin 441 in the first direction A may be of a circular shape, an elliptical shape, a square shape, or a rhombic shape. The circular and elliptical heat dissipation fins 441 are easy to process, and the square and rhombic heat dissipation fins 441 have better turbulence effect on the cooling liquid.

In an embodiment, the flow guide fin 442 is adjacent to a corner area of the first liquid cooling plate 400. In this embodiment of this application, the corner area is a turning point on the flow path of the cooling liquid, and a flow direction of the cooling liquid usually changes greatly in the corner area. If no flow guide fin 442 guides flow of the cooling liquid, a part of cooling liquid may accumulate in the corner area due to a slow flow speed in a redirection process, to form a flow dead area. This is not conducive to even distribution of the cooling liquid in the first liquid cooling plate 400. In this embodiment of this application, the flow guide fin 442 can forcibly make the cooling liquid flow in an extension direction of the flow guide fin 442, to improve heat dissipation efficiency of the cooling liquid. In an embodiment, an end face of the flow guide fin 442 in the first direction A may be of a linear shape, an arc shape, or a sickle shape, or a combination of the foregoing shapes.

Still refer to FIG. 3. In an embodiment, at least one of the flow guide fins 442 or the heat dissipation fins 441 on the two sides of the first separation protrusion 421 differs in at least one of a quantity, a shape, or an arrangement manner.

In this embodiment of this application, the heat dissipation fins 441 on the two sides of the first separation protrusion 421 differ in at least one of a quantity, a shape, or an arrangement manner. Alternatively, the flow guide fins 442 on the two sides of the first separation protrusion 421 differ in at least one of a quantity, a shape, or an arrangement manner. Alternatively, the heat dissipation fins 441 on the two sides of the first separation protrusion 421 differ in at least one of a quantity, a shape, or an arrangement manner, and the flow guide fins 442 on the two sides of the first separation protrusion 421 differ in at least one of a quantity, a shape, or an arrangement manner. In this embodiment of this application, layouts of the heat dissipation fins 441 and the flow guide fins 442 can be adjusted based on actual heat dissipation requirements of the electrical components 300.

Still refer to FIG. 3 and FIG. 4. In an embodiment, the first liquid cooling plate 400 includes a flow channel groove 451. An orientation of a groove opening of the flow channel groove 451 is away from an electrical component 300 of the on-board charger 11 in the first direction A, and the flow channel groove 451 is integrated on a surface that is of the cover plate 100 and that is away from the accommodation groove 200 in the first direction A.

The cover plate 100 includes a sealing plate 110. The sealing plate 110 is distributed on an outer side of the accommodation groove 200, and the sealing plate 110 is configured to cover the groove opening of the flow channel groove 451 in the first direction A.

In this embodiment of this application, the flow channel groove 451 of the first liquid cooling plate 400 is integrated into the cover plate 100, to help enhance structural strength of the flow channel groove 451. In addition, in this embodiment of this application, integration of the on-board charger 11 can be improved, which helps implement a lightweight design of the on-board charger 11 and optimize a layout of the powertrain 10.

In this embodiment of this application, air in the accommodation groove 200 expands in volume after being heated, and the air tends to move upward to the cover plate 100. The flow channel groove 451 of the first liquid cooling plate 400 is integrated into the cover plate 100, which facilitates heat exchange between the first liquid cooling plate 400 and the hot air in the accommodation groove 200. In addition, the first liquid cooling plate 400 does not occupy space in the accommodation groove 200, which helps optimize layouts of the plurality of electrical components 300 in the accommodation groove 200.

In this embodiment of this application, the first liquid cooling plate 400 and the second liquid cooling plate 500 can further indirectly cool the electrical component 300. Specifically, heat generated by the electrical component 300 with the loss density increases the temperature in the accommodation groove 200. After air is heated, the air expands in volume and decreases in a density, and therefore, the hot air tends to flow upward to the cover plate 100. The flow channel groove 451 of the first liquid cooling plate 400 is integrated into the cover plate 100, and cooling liquid in the flow channel groove 451 can perform heat exchange with the hot air, and carry away heat in the air. This helps reduce a temperature in the accommodation groove 200 and effectively improve heat dissipation efficiency.

In this embodiment of this application, the cooling liquid with a low temperature in the housing liquid inlet flow channel 600 flows into the first liquid cooling plate 400 through the first communication hole 411. The first liquid cooling plate 400 is farther away from a groove bottom of the accommodation groove 200 than the second liquid cooling plate 500, to facilitate heat exchange between the cooling liquid with the low temperature in the first liquid cooling plate 400 and the hot air rising in the accommodation groove 200. This reduces the temperature in the accommodation groove 200.

Still refer to FIG. 3 to FIG. 6. In an embodiment, an area of a surface of the first liquid cooling plate 400 in a second direction B is greater than an area of a surface of the second liquid cooling plate 500 in the second direction B, and the second direction B is perpendicular to the first direction A.

In this embodiment of this application, the second direction B is perpendicular to an arrangement direction of the first liquid cooling plate 400 and the second liquid cooling plate 500, and the area of the surface of the first liquid cooling plate 400 in the second direction B is greater than the area of the surface of the second liquid cooling plate 500 in the second direction B. This can increase a contact area between the first liquid cooling plate 400 and the hot air, to help reduce the temperature in the accommodation groove 200. In addition, the first liquid cooling plate 400 is integrated into the cover plate 100. Extending a length of the first liquid cooling plate 400 in the second direction B does not interfere with layouts of the electrical components 300 in the accommodation groove 200. The second liquid cooling plate 500 is located in the accommodation groove 200. If the area of the surface of the second liquid cooling plate 500 in the second direction B is excessively large, clearance with the electrical component 300 may need to be considered.

Refer to FIG. 4 and FIG. 12. In an embodiment, a surface that is of the cover plate 100 and that faces the accommodation groove 200 in the first direction A includes a plurality of fastening protrusions 130. The plurality of fastening protrusions 130 are configured to fasten the circuit board 301 and the electrical components 300 of the on-board charger 11. A surface that is of the circuit board 301 and that faces the cover plate in the first direction A is used to fasten the electrical components 300.

In this embodiment of this application, the first liquid cooling plate 400 is integrated on the surface that is of the cover plate 100 and that is away from the accommodation groove 200, and the surface that is of the cover plate 100 and that faces the accommodation groove 200 is used to fasten the electrical components 300. The fastening protrusion 130 is a part of the cover plate 100, and that the fastening protrusion 130 is fastened to the electrical components 300 is equivalent to that the cover plate 100 is in direct contact with the electrical components. This can shorten a heat transmission path between the electrical components 300 and the first liquid cooling plate 400 without occupying space of the accommodation groove 200 by the first liquid cooling plate 400, and can further reduce a risk of cooling liquid leakage.

Refer to FIG. 4 and FIG. 5. In an embodiment, the housing liquid inlet flow channel 600 and the housing liquid outlet flow channel 700 are distributed on an outer side of the accommodation groove 200.

In this embodiment of this application, the housing liquid inlet flow channel 600 communicates with the flow channel of the first liquid cooling plate 400 through the first communication hole 411, and the housing liquid outlet flow channel 700 communicates with the flow channel of the first liquid cooling plate 400 through the second communication hole 412. The flow channel groove 451 is distributed on a surface that is of the cover plate 100 and that is away from the groove bottom the accommodation groove 200. The first communication hole 411 and the second communication hole 412 are distributed on a groove bottom of the flow channel groove 451. In other words, the first communication hole 411 and the second communication hole 412 are closer to the outer side of the accommodation groove 200 than the second liquid cooling plate 500. If the housing liquid inlet flow channel 600 and the housing liquid outlet flow channel 700 are distributed on an inner side of the accommodation groove 200, difficulty and processing costs of communicating the housing liquid inlet flow channel 600 and the housing liquid outlet flow channel 700 with the first liquid cooling plate 400 are increased, and the housing liquid inlet flow channel 600 and the housing liquid outlet flow channel 700 further occupy internal space of the accommodation groove 200.

Still refer to FIG. 5. In an embodiment, an outlet of the housing liquid inlet flow channel 600 is configured to communicate with the first communication hole 411, and an orientation of the outlet of the housing liquid inlet flow channel 600 is the same as an orientation of a groove opening of the accommodation groove 200.

The surface that is of the cover plate 100 and that faces the accommodation groove 200 in the first direction A is used to fasten a flow channel communication component 900, and the flow channel communication component 900 is distributed on the outer side of the accommodation groove 200. One end of the flow channel communication component 900 is configured to cover the first communication hole 411, and the other end of the flow channel communication component 900 is configured to be embedded in the outlet of the housing liquid inlet flow channel 600.

In this embodiment of this application, the flow channel communication component 900 is configured for communication of the outlet of the housing liquid inlet flow channel 600 and the first communication hole 411 of the first liquid cooling plate 400. Both the housing liquid inlet flow channel 600 and the flow channel communication component 900 are distributed on the outer side of the accommodation groove 200, to facilitate checking of communication and reduce communication difficulty. The one end of the flow channel communication component 900 covers the first communication hole 411, and the other end of the flow channel communication component 900 is embedded in the outlet of the housing liquid inlet flow channel 600, so that the cooling liquid does not leak at a joint between the flow channel communication component 900, and the housing liquid inlet flow channel 600 and the cover plate 100.

Still refer to FIG. 4. In an embodiment, an inlet of the housing liquid outlet flow channel 700 is configured to receive the cooling liquid output by the first liquid cooling plate 400, and an outlet of the housing liquid outlet flow channel 700 is configured to drain the cooling liquid from the on-board charger 11.

The inlet of the housing liquid outlet flow channel 700 is distributed on a groove wall of the accommodation groove 200. The outlet of the housing liquid outlet flow channel 700 is distributed on the outer side of the accommodation groove 200, and an orientation of the inlet of the housing liquid outlet flow channel 700 is opposite to an orientation of the second communication hole 412. The second communication hole 412 is embedded in the inlet of the housing liquid outlet flow channel 700.

In this embodiment of this application, the first liquid cooling plate 400 is integrated into the cover plate 100, and the cover plate 100 and the accommodation groove 200 are stacked in the first direction A. The inlet of the housing liquid outlet flow channel 700 is arranged on the groove wall of the accommodation groove 200, and the orientation of the inlet of the housing liquid outlet flow channel 700 is opposite to the orientation of the second communication hole 412, to help shorten a transmission distance of the cooling liquid between the second communication hole 412 and the housing liquid outlet flow channel 700. The outlet of the housing liquid outlet flow channel 700 is arranged on the outer side of the accommodation groove 200, and the second communication hole 412 is embedded in the inlet of the housing liquid outlet flow channel 700, to prevent the cooling liquid with a high temperature from leaking into the accommodation groove 200.

Refer to FIG. 3 and FIG. 4. In an embodiment, the groove wall of the accommodation groove 200 includes a first groove wall section 210 and a second groove wall section 220. The first groove wall section 210 and the second groove wall section 220 are arranged opposite to each other in the second direction B, and the second direction B is perpendicular to the first direction A.

A distance between the first groove wall section 210 and each of the first communication hole 411, the second communication hole 412, the third communication hole 413, the fourth communication hole 414, the outlet of the housing liquid inlet flow channel 600, and the inlet of the housing liquid outlet flow channel 700 is less than a distance between the second groove wall section 220 and each of the first communication hole 411, the second communication hole 412, the third communication hole 413, the fourth communication hole 414, the outlet of the housing liquid inlet flow channel 600, and the inlet of the housing liquid outlet flow channel 700.

In this embodiment of this application, the first communication hole 411, the second communication hole 412, the third communication hole 413, and the fourth communication hole 414 are all adjacent to the first groove wall section 210 of the accommodation groove 200, so that the first communication hole 411, the second communication hole 412, the third communication hole 413, and the fourth communication hole 414 are compactly arranged. This reduces difficulty and costs of processing the flow channel groove. The third communication hole 413 and the fourth communication hole 414 are adjacent to the first groove wall section 210 of the accommodation groove 200, so that the first communication port 140 and the second communication port 150 are also close to the accommodation groove 200 in the second direction B, and space that is in the accommodation groove 200 and that is for accommodating the electrical components 300 can be increased. The first communication hole 411 and the second communication hole 412 are adjacent to the first groove wall section 210 of the accommodation groove 200, so that the first communication hole 411 and the second communication hole 412 communicate with the housing liquid inlet flow channel 600 and the housing liquid outlet flow channel 700 that are distributed on the outer side of the accommodation groove 200.

It should be noted that the first communication hole 411, the second communication hole 412, the third communication hole 413, and the fourth communication hole 414 are all close to the first groove wall section 210 of the accommodation groove 200, but this does not mean that a path of cooling liquid flowing into the third communication hole through the first communication hole 411 413 and a path of cooling liquid flowing into the second communication hole 412 through the fourth communication hole 414 are definitely short. Refer to FIG. 6 and FIG. 8. As shown in FIG. 8, a distance between the first groove wall section 210 and each of the third communication hole 413 and the fourth communication hole 414 is less than a distance between the second groove wall section 220 and each of the third communication hole 413 and the fourth communication hole 414, and a distance between the first groove wall section 210 and each of the first communication hole 411 and the second communication hole 412 is greater than a distance between the second groove wall section 220 and each of the first communication hole 411 and the second communication hole 412. With reference to FIG. 6 and FIG. 8, it can be learned that a length of a path between each of the first communication hole 411 and the second communication hole 412 and each of the third communication hole 413 and the fourth communication hole 414 is related to relative locations of the four communication holes, and are further affected by shapes and layouts of the first separation protrusion 421 and the second separation protrusion 422 and a location of the split flow channel 800.

In an embodiment, the distance between the first groove wall section and each of the first communication hole and the second communication hole is less than the distance between the second groove wall section and each of the first communication hole and the second communication hole. The distance between the second groove wall section and each of the third communication hole and the fourth communication hole is less than the distance between the first groove wall section and each of the third communication hole and the fourth communication hole. In embodiments of this application, the first communication hole and the second communication hole, and the third communication hole and the fourth communication hole are respectively adjacent to the first groove wall section and the second groove wall section, which helps extend a flow path of the cooling liquid between the first communication hole and the third communication hole and between the second communication hole and the fourth communication hole.

The foregoing describes in detail the on-board charger with the three-dimensional liquid cooling loop, the powertrain, and the electric vehicle provided in embodiments of this application. Specific examples are used in this specification to describe a principle and embodiments of this application, and the foregoing embodiments are merely used to help understand the method and core ideas of this application. In addition, a person of ordinary skill in the art can make variations and modifications to specific embodiments and application scopes according to the ideas of this application. In conclusion, the content of this specification shall not be construed as a limitation to this application.

## Claims

1. An on-board charger with a three-dimensional liquid cooling loop, wherein an electrical component of the on-board charger is configured to: charge and discharge a power battery of an electric vehicle, a housing of the on-board charger comprises a cover plate and an accommodation groove, the cover plate is configured to enclose the accommodation groove in a first direction, and the accommodation groove is configured to accommodate the electrical component of the on-board charger, wherein
the three-dimensional liquid cooling loop of the on-board charger comprises a first liquid cooling plate, a second liquid cooling plate, a split flow channel, a housing liquid inlet flow channel, and a housing liquid outlet flow channel, wherein the first liquid cooling plate and the second liquid cooling plate are stacked in the first direction, and the electrical component of the on-board charger is arranged between the first liquid cooling plate and the second liquid cooling plate;
the first liquid cooling plate comprises a first separation protrusion, a second separation protrusion, a first communication hole, a second communication hole, a third communication hole, and a fourth communication hole, wherein the first separation protrusion and the second separation protrusion are configured to separate a flow channel of the first liquid cooling plate into a first heat dissipation plate flow channel and a second heat dissipation plate flow channel, the split flow channel is configured for communication of the first heat dissipation plate flow channel and the second heat dissipation plate flow channel, the first separation protrusion is distributed between the first communication hole and the second communication hole, and the second separation protrusion is distributed between the third communication hole and the fourth communication hole; and
the first communication hole and the third communication hole are distributed on the first heat dissipation plate flow channel, and the second communication hole and the fourth communication hole are distributed on the second heat dissipation plate flow channel; the first heat dissipation plate flow channel is configured to receive cooling liquid from the housing liquid inlet flow channel through the first communication hole, and the first heat dissipation plate flow channel is configured to deliver the cooling liquid to an inlet of a flow channel of the second liquid cooling plate through the third communication hole; and the second heat dissipation plate flow channel is configured to receive the cooling liquid from an outlet of the flow channel of the second liquid cooling plate through the fourth communication hole, the second heat dissipation plate flow channel is configured to receive the cooling liquid from the first heat dissipation plate flow channel through the split flow channel, and the second heat dissipation plate flow channel is configured to deliver the cooling liquid to the housing liquid outlet flow channel through the second communication hole.

2. The on-board charger according to claim 1, wherein the split flow channel is distributed in a gap between the first separation protrusion and the second separation protrusion.

3. The on-board charger according to claim 1, wherein the split flow channel is distributed between the inlet of the flow channel of the second liquid cooling plate and the outlet of the flow channel of the second liquid cooling plate, an inlet of the split flow channel is configured to communicate with the first heat dissipation plate flow channel through the inlet of the flow channel of the second liquid cooling plate, and the outlet of the split flow channel is configured to communicate with the second heat dissipation plate flow channel through the outlet of the flow channel of the second liquid cooling plate.

4. The on-board charger according to claim 1, wherein a surface that is of the first liquid cooling plate and that faces the second liquid cooling plate in the first direction comprises a first communication port and a second communication port, a surface that is of the second liquid cooling plate and that faces the first liquid cooling plate in the first direction is used to fasten the first communication port and the second communication port, the first communication port is configured for communication of the third communication hole and the inlet of the flow channel of the second liquid cooling plate, and the second communication port is configured for communication of the fourth communication hole and the outlet of the flow channel of the second liquid cooling plate; and
the split flow channel is distributed between the first communication port and the second communication port, an inlet of the split flow channel is configured to communicate with the first heat dissipation plate flow channel through the first communication port, and an outlet of the split flow channel is configured to communicate with the second heat dissipation plate flow channel through the second communication port.

5. The on-board charger according to any one of claims 1 to 4, wherein the first liquid cooling plate further comprises a plurality of heat dissipation fins and a plurality of flow guide fins, wherein
the first separation protrusion is configured to separate the first communication hole from the second communication hole, the plurality of heat dissipation fins are distributed on two sides of the first separation protrusion, the plurality of flow guide fins are distributed on the two sides of the first separation protrusion, a length of each flow guide fin is greater than a length of each heat dissipation fin, and a gap between two adjacent heat dissipation fins is less than a gap between two adjacent flow guide fins.

6. The on-board charger according to claim 5, wherein at least one of the flow guide fins or the heat dissipation fins on the two sides of the first separation protrusion differs in at least one of a quantity, a shape, or an arrangement manner.

7. The on-board charger according to any one of claims 1 to 6, wherein the first liquid cooling plate comprises a flow channel groove, an orientation of a groove opening of the flow channel groove is away from the electrical component of the on-board charger in the first direction, and the flow channel groove is integrated on a surface that is of the cover plate and that is away from the accommodation groove in the first direction; and
the cover plate comprises a sealing plate, the sealing plate is distributed on an outer side of the accommodation groove, and the sealing plate is configured to cover the groove opening of the flow channel groove in the first direction.

8. The on-board charger according to claim 7, wherein an area of a surface of the first liquid cooling plate in a second direction is greater than an area of a surface of the second liquid cooling plate in the second direction, and the second direction is perpendicular to the first direction.

9. The on-board charger according to claim 7 or 8, wherein a surface that is of the cover plate and that faces the accommodation groove in the first direction comprises a plurality of fastening protrusions, the plurality of fastening protrusions are configured to fasten a circuit board and the electrical component of the on-board charger, and a surface that is of the circuit board and that faces the cover plate in the first direction is used to fasten the electrical component.

10. The on-board charger according to any one of claims 7 to 9, wherein the housing liquid inlet flow channel and the housing liquid outlet flow channel are distributed on the outer side of the accommodation groove.

11. The on-board charger according to claim 10, wherein an outlet of the housing liquid inlet flow channel is configured to communicate with the first communication hole, and an orientation of the outlet of the housing liquid inlet flow channel is the same as an orientation of a groove opening of the accommodation groove, wherein
the surface that is of the cover plate and that faces the accommodation groove in the first direction is used to fasten a flow channel communication component, the flow channel communication component is distributed on the outer side of the accommodation groove, one end of the flow channel communication component is configured to cover the first communication hole, and the other end of the flow channel communication component is configured to be embedded in the outlet of the housing liquid inlet flow channel.

12. The on-board charger according to claim 11, wherein an inlet of the housing liquid outlet flow channel is configured to receive the cooling liquid output by the first liquid cooling plate, and an outlet of the housing liquid outlet flow channel is configured to drain the cooling liquid from the on-board charger, wherein
the inlet of the housing liquid outlet flow channel is distributed on a groove wall of the accommodation groove, the outlet of the housing liquid outlet flow channel is distributed on the outer side of the accommodation groove, an orientation of the inlet of the housing liquid outlet flow channel is opposite to an orientation of the second communication hole, and the second communication hole is embedded in the inlet of the housing liquid outlet flow channel.

13. The on-board charger according to claim 12, wherein the groove wall of the accommodation groove comprises a first groove wall section and a second groove wall section, the first groove wall section and the second groove wall section are arranged opposite to each other in the second direction, and the second direction is perpendicular to the first direction, wherein
a distance between the first groove wall section and each of the first communication hole, the second communication hole, the third communication hole, the fourth communication hole, the outlet of the housing liquid inlet flow channel, and the inlet of the housing liquid outlet flow channel is less than a distance between the second groove wall section and each of the first communication hole, the second communication hole, the third communication hole, the fourth communication hole, the outlet of the housing liquid inlet flow channel, and the inlet of the housing liquid outlet flow channel.

14. A powertrain, wherein the powertrain comprises a drive motor, a reducer, and the on-board charger according to any one of claims 1 to 13, wherein the on-board charger is configured to charge and discharge a power battery, the power battery is configured to supply power to the drive motor, and the drive motor is configured to be in transmission connection to the reducer.

15. An electric vehicle, wherein the electric vehicle comprises a power battery and the powertrain according to claim 14, and the powertrain is configured to: receive power supplied by the power battery, and drive wheels of the electric vehicle.
